(19) **Europäisches Patentamt / European Patent Office / Office européen des brevets**

(11) **EP 2 291 937 B1**

(12) **EUROPEAN PATENT SPECIFICATION**

(45) Date of publication and mention
of the grant of the patent:
**25.12.2013 Bulletin 2013/52**

(21) Application number: **09769003.6**

(22) Date of filing: **25.06.2009**

(51) Int Cl.:
*H04L 1/00* (2006.01)     *H04W 4/06* (2009.01)
*H04L 27/02* (2006.01)    *H04N 7/24* (2011.01)
*H04H 20/67* (2008.01)

(86) International application number:
**PCT/EP2009/004590**

(87) International publication number:
**WO 2009/156154 (30.12.2009 Gazette 2009/53)**

(54) **SYSTEM, METHOD AND COMPUTER PROGRAM PRODUCT FOR PRODUCING A SINGLE FREQUENCY NETWORK FOR ATSC MOBILE/HANDHELD SERVICES**

SYSTEM, VERFAHREN UND COMPUTERPROGRAMMPRODUKT ZUR HERSTELLUNG EINES EINZELFREQUENZNETZWERKS FÜR ATSC-MOBIL/HANDGERÄTE-DIENSTE

SYSTÈME, PROCÉDÉ ET PROGRAMME D'ORDINATEUR POUR PRODUIRE UN RÉSEAU À FRÉQUENCE UNIQUE POUR DES SERVICES MOBILE/PORTABLES ATSC

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **25.06.2008  US 75523 P**
**04.07.2008  DE 102008031796**
**06.11.2008  US 111761 P**
**11.11.2008  DE 102008056703**

(43) Date of publication of application:
**09.03.2011  Bulletin 2011/10**

(73) Proprietor: **Rohde & Schwarz GmbH & Co. KG
81671 München (DE)**

(72) Inventors:
• **SIMON, Michael Frederick
MD 21701 (US)**
• **KRAMER, Michael
86862 Dillishausen (DE)**

(74) Representative: **Körfer, Thomas
Mitscherlich & Partner
Patent- und Rechtsanwälte
Sonnenstrasse 33
80331 München (DE)**

(56) References cited:
**EP-A1- 1 670 150      WO-A1-2007/046672
WO-A1-2007/114653   WO-A2-2006/128051
US-A1- 2006 245 516**

**Description**

BACKGROUND

Field

The present invention generally relates to ATSC digital television ("DTV") and mobile/handheld ("M/H") broadcast systems, and more particularly to data frame synchronization.

Related Art

A single-frequency network ("SFN") is a collection of transmitters operating on the same frequency for carrying the same information to receivers in a given area. The transmitters emit identical signals, several of which may be received more or less simultaneously by individual receivers. One application of SFNs is for transmission of digitally encoded data for digital television ("DTV"), the system and related standards for which have been established by the Advanced Television Systems Committee ("ATSC"). Under the ATSC's DTV standard (or A/53 standard), it is possible to transmit large amounts of data including high definition pictures, high quality sound, multiple standard definition pictures, and other ancillary related or unrelated communications, which may be accessible by using, for example, a stationary receiver such as a computer or television set. Such stationary receivers are also interchangeably referred to as "fixed" receivers. The data broadcasted to stationary receivers are interchangeably referred to as "normal data," "main service data" and "main stream data."

Another application of SFNs is for transmission of digitally encoded data for mobile/handheld ("M/H") devices, the system and related standards for which are currently being established as a candidate standard, the document for which is designated the ATSC A/153 candidate standard (also referred to as the "M/H DTV candidate standard"). Under the A/153 candidate standard, M/H broadcasting services share the same RF channel as the ATSC A/53 broadcast service and are provided using a portion of the ~19.39 Mbps of the ATSC 8-level vestigial sideband ("8-VSB") signal bandwidth.

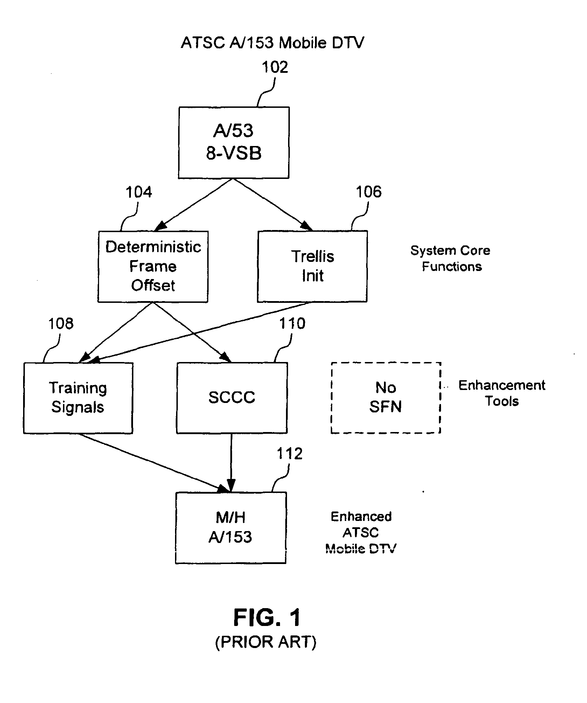

FIG. 1 depicts the system core functions and enhancement tools that have been added to the A/53 standard 102 to form the A/153 candidate standard 112. Generally, the A/53 candidate standard is based on the VSB modulation as is the standard ATSC A/53 broadcast service, coupled with additional forward error correction mechanisms and known training sequences to aid mobile receivers. As shown in FIG. 1, the A/153 candidate standard requires, among other things, known data frame offsets 104 to map data packets with the A/153 standard's frame structure, and pre-coder and trellis encoder initialization 106 (pre-coder and trellis encoder are collectively referred to herein as a "trellis coder"), which provides in part the mechanism for creating known training sequences. Techniques for providing VSB data frame and trellis coder synchronization are described in U.S. Patent No. 7,532,677 (the '677 patent).

The system achieves the robustness needed for mobile reception by adding extra training sequences 108 and several levels of forward error correction ("FEC"), one at the packet layer by a 2D Reed Solomon/CRC code, and another at the physical layer by a serial concatenated convolution code ("SCCC") 110, which is formed together with the trellis coding of the 8-VSB exciter. A parallel concatenated code ("PCCC") is also used for robust signalling to the mobile receiver.

In US 2006/0245516 A1 systems, methods, apparatus and computer program products are provided for signaling a deterministic mapping corresponding to a service. The deterministic mapping is inserted within an in-band ATSC vestigial sideband broadcast signal or an out-of-band signal and transmitted to receivers capable of consuming the service.

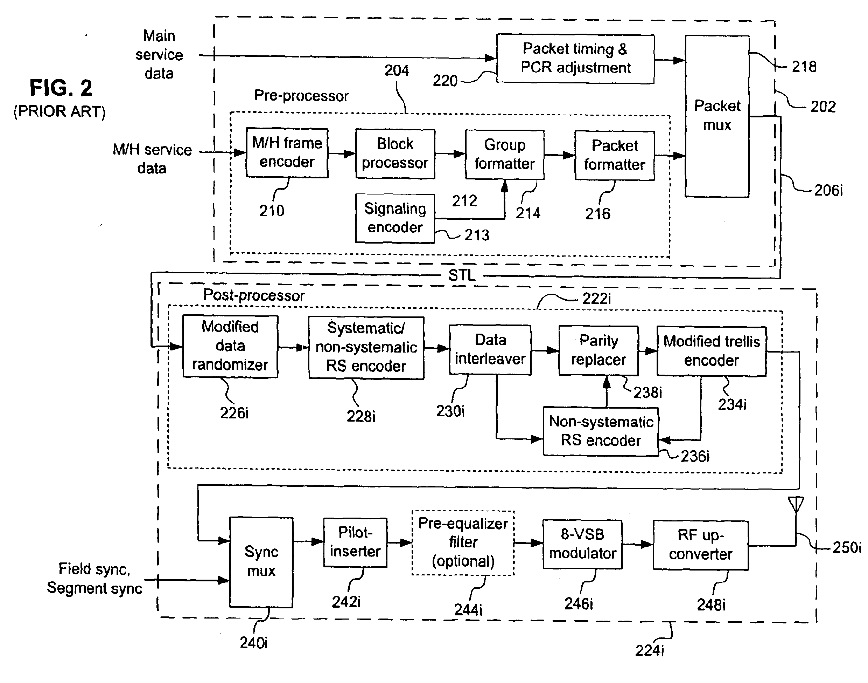

FIG. 2 depicts a block diagram of an ATSC M/H transmission system including a pre-processor 204 (also referred to as an "M/H multiplexer") and a post-processor 222), $222_2$,.., $222_i$,.., $222_n$. Generally, the M/H system is a dual-stream system including an ATSC service multiplexer for existing digital television services or "main service" data and an M/H service multiplexer for one or more mobile and handheld services or "M/H service" data. An example of such a transmission system is described in U.S. Patent No. 7,532,857.

As shown in FIG. 2, the main service and M/H service multiplexers feed into a head-end 202 (e.g., in a studio) where signal processing of main and M/H service data is performed. The processed data is then communicated over a studio-transmitter link ("STL") $206_1$, $206_2$,.., $206_i$,.., $206_n$ to a post-processor $222_1$, $222_2$,.., $222_i$,.., $222_n$ at a remotely positioned transmitter $224_1$, $224_2$,-.., $224_i$,.., $224_n$. As described in the A/153 candidate standard, in pre-processor 204, M/H service data are encoded with a Reed-Solomon/CRC ("RS/CRC") coding in the M/H Frame encoder 210, a serial concatenated convolutional encoder in the block processor 212. Pre-processor 204 also generates signalling information such as status data such as the length, the periodicity and the sequence number of data units for each service, the time marker for transmission time of each data unit, and so on which are PCCC (Parallel concentrated code) encoded by a signalling encoder 213 and combined with MH encoded data in the group formatter 214. The encoded M/H payload data containing M/H training signals, additional control and status data are formatted into a MH Group by the group formatter 214 and formed into Mobile Handheld Encapsulated (MHE) transport stream (TS) data packets with a packet identifier ("PID") (in a normal ATSC TS header) by the packet formatter 216 at the end of pre-processing.

Markers in TS data packets with main service data are modified by a packet timing and program clock reference (PCR) adjustment unit 220 which performs packet timing and PCR adjustment. A consecutively positioned packet multiplexer 218 multiplexes the normal TS data packets with MHE TS data packets to form the nominal 19,392658 bit/s data rate specified in the A/53 standard.

At each remote positioned transmitter $224_1$, $224_2$,.., $224_i$,.., $224_n$, in the post-processor $222_1$, $222_2$,..., $222_i$,.., $222_n$, the normal data packets are channel coded as specified in A/53 to maintain compatibility with normal ATSC receivers. This includes stages which provide data randomization by a data randomizer $226_1$, $226_2$,..., $226_i$, $226_n$, systematic/non-systematic RS encoding by encoder $228_1$, data interleaving by interleaver $230_1$, $230_2$,..., $230_i$, $230_n$, and trellis encoding by trellis encoder $234_1$, $234_2$,..., $234_i$, $234_n$. All stages in the post processor $222_1$, $222_2$,.., $222_i$,.., $222_n$ other than data interleaver $230_i$ have a dual mode (i.e. normal/MHE) capability which is selected per the type of packet (normal/MHE) being processed. Each post-processor $222_1$, $222_2$,..., $222_i$,.., $222_n$ is followed by a synchronization multiplexer $240_1$, $240_2$,.., $240_i$,.., $240_n$ for inserting synchronizing data (e.g., data field segments and data segment sync). Signalling is inserted in the data field sync to signal to receivers when MH mode is active or not, a pilot inserter $242_1$, $242_2$,.., $242_i$,.., $242_n$ for inserting pilot symbols in the transport data stream, an optional pre-equalizer $244_1$, $244_2$,.., $244_i$,.., $244_n$, an 8-VSB modulator $246_1$, $246_2$,.., $246_i$,.., $246_n$, an RF-up-converter $248_1$, $248_2$,.., $248_i$,.., $248_n$ for RF signal processing and a transmitter antenna $250_1$, $250_2$,.., $250_i$,.., $250_n$.

Non-Systematic RS parity bytes are calculated and placed in known positions within each MH Group by Non-Systematic RS encoding in encoder $228_1$, $228_2$, ..., $228_i$, $228_n$, these positions enable, in part, the generation of six long MH training signals in each MH Group. Each of the six training sequences begins with 12 initialization bytes (one for each I of 12 trellis encoders) and is used by modified trellis encoder 234i, $234_2$, ..., $234_i$, $234_n$ to initialize all trellis states to a known zero value before the following known training data begins to enter the trellis encoder. This action will create known repeatable training symbols for MH receivers. The encoder $228_1$, $228_2$, ..., $228_i$, $228_n$ inserts the non-systematic parity bytes prior to trellis initialization in modified trellis encoder $234_1$, $234_2$, ..., $234_i$, $234_n$. Some parity will become erroneous after the training initialization bytes are processed (i.e., values are changed) in modified trellis encoder according to the A/153 candidate standard. Accordingly, modified trellis encoder $234_1$, $234_2$, ..., $234_i$, $234_n$ supplies these changed initialization bytes to a non-systematic RS encoder $236_1$, $236_2$, ..., $236_i$, $236_n$, which (non-systematically) re-calculates the RS parity of corresponding M/H packets using the changed data and original packet data from data interleaver $230_1$, $230_2$, ..., $230_i$, $230_n$. The new RS parity bytes obtained by performing the non-systematic RS re-encoding process are supplied to RS parity replacer $238_1$, $238_2$, ..., $238_i$, $238_n$, which selects the output of the data interleaver $230_1$, $230_2$, ..., $230_i$, $230_n$ or the output of non-systematic RS encoder $236_1$, $236_2$, ..., $236_i$, $236_n$ with the re-calculated RS parity.

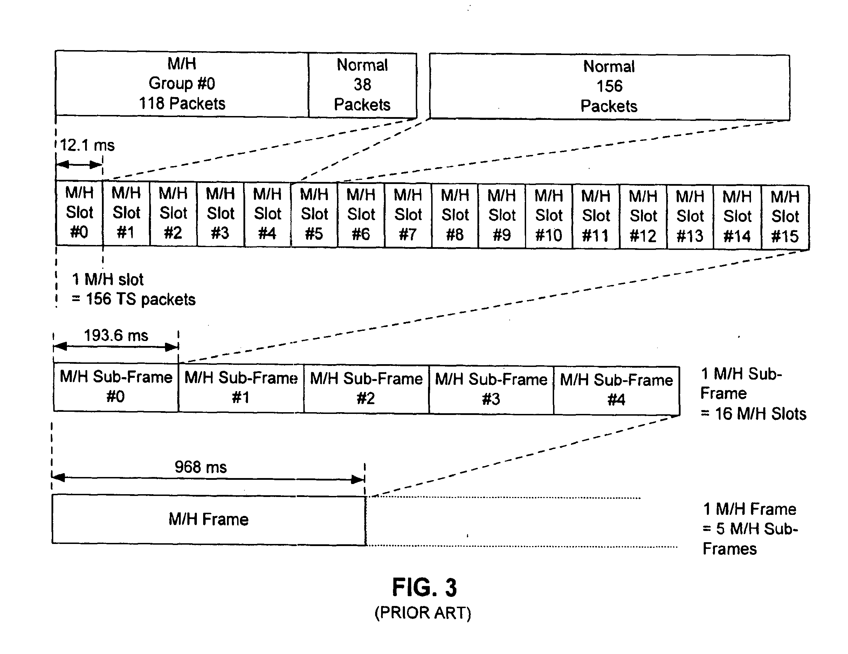

FIG. 3 depicts the structure of an M/H Frame according to the A/153 candidate standard. As shown in FIG. 3, a data stream of consecutively transmitted M/H data frames includes 5 M/H Sub-Frames. Each sub-frame contains 156 TS data packets and each TS data packet is 188 bytes. Each set of 156 TS data packets is referred to as an M/H Slot which can contain a combination of M/H data packets and normal data packets, or only normal data packets. In normal data packets, only digital data for stationary (or fixed) receivers are transferred, whereas M/H data packets contain only data for M/H receivers.

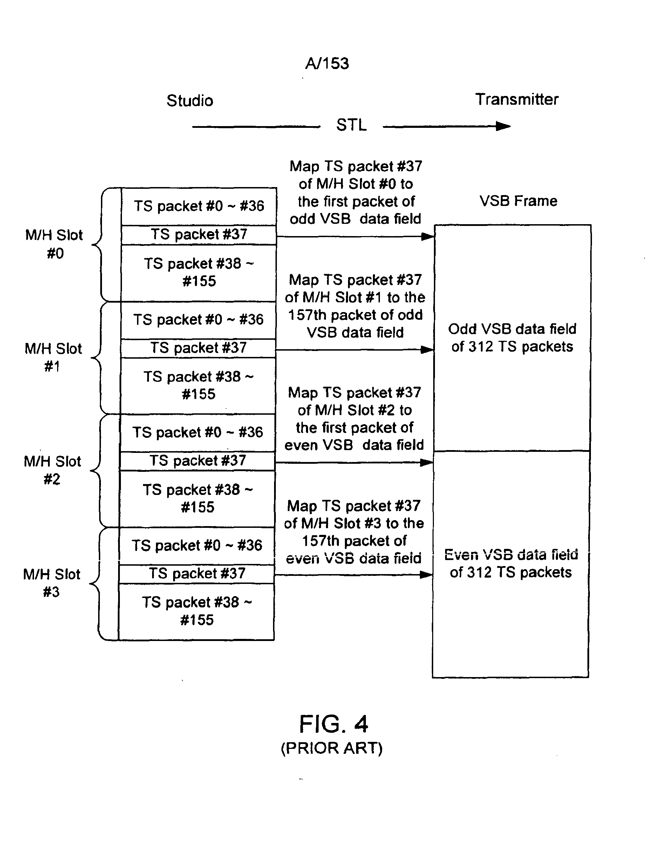

More specifically, an M/H Slot may contain 118 data packets with data for M/H receivers (*i.e.,* "M/H Group") and 38 data packets of normal data for stationary receivers, *i.e.,* "normal 38 packets". Alternatively, an M/H Slot may contain 156 data packets of normal data only *(i.e.,* "normal 156 packets" with data for stationary or "main stream" receivers). The mapping of the received ATSC M/H packets to positions in an 8-level vestigial sideband ("8-VSB") data field is shown in FIG. 4. One purpose for this data mapping is to ensure MHE TS packets sent from pre-processor 204 are synchronized in and with post-processor $222_1$, $222_2$, ..., $222_i$, $222_n$ in the MH exciter. This mapping also enables MH receivers to tune and select the MH data wanted during reception by ensuring the MH data will be at known symbol positions in the physical layer VSB Frame. As shown in FIG. 4, the 38th data packet (#37) in an ATSC M/H Group received in the first data slot #0 of a first sub-frame #0 in the received ATSC M/H data frame is mapped to the first position for a data packet in an odd VSB data field.

The 38th data packet in the ATSC M/H Group received in Slot# 2 is mapped to the first position for a data packet in an even VSB data field. The 38th data packet in the ATSC M/H Group received in Slot # 1 is mapped to the 157th position for a data packet in an odd VSB data field. And, the 38th data packet in the ATSC M/H Group received in Slot # 3 is mapped to the 157th position for a data packet in an even VSB data field.

According to the A/153 candidate standard, an ATSC M/H Group with a data structure corresponding to FIG. 4 is created in the pre-processor 204 (FIG. 2) in the ATSC M/H channel of the head-end 202 (FIG. 2). In total, 45 dummy bytes are placed in the 118 MHE packets of an ATSC M/H Group. These A/153 dummy bytes are used as padding bytes and serve no other useful purpose. Some of these dummy bytes will be used in the present invention to create a point to point signalling channel between pre-processor and post-processor. There are 13 dummy bytes in the first two (2) MHE packets including eight (8) dummy bytes in the 1st MHE packet and five (5) dummy bytes in the 2nd MHE packet. When transmitted between transmitters and receivers, all these dummy bytes typically have a fixed pre-selected value, *e.g.* 0xAF.

Since the pre-processor 204 and post-processor(s) $222_1$, $222_2$, ..., $222_i$, $222_n$ (FIG. 2) are remote from each other, they need to be synchronized to one another (*i.e.,* a deterministic mapping with a known packet offset between the start of a VSB field and the MHE packets carrying enhanced data must be set). There also needs to be a way for the post processor 222i to distinguish MHE packets and normal data packets when the packets are received at the exciter. Currently, neither the A/53 nor A/153-candidate standards provide mechanisms for signalling a mode or for synchronization between the pre- and post processors, or for identifying the MHE packets in the exciter. In addition, there is a need to provide a mechanism to switch between modes in ATSC SFN, particularly ATSC SFN with M/H services and ATSC SFN without M/H services, and vice versa. U.S. Patent Application No. 12/468,938 (the "'938 application"), filed on May 20, 2009, publication number US 2010/111109 A1, describes example mechanisms for performing such synchronization and identification for a single transmitter.

As described in the '938 application, to synchronize the pre-processor with the post-processor, each exciter uses signalling information determined in the pre-processing stage at the head-end. This signalling information is inserted by the packet multiplexer (FIG. 2, 218) in particular byte positions in the MH Group that are set aside for dummy bytes specified in the A/153 candidate standard.

BRIEF DESCRIPTION

The example embodiments described herein meet the above-identified needs by providing apparatus, systems, methods and computer program products according to claims 1, 6 and 11 for producing a single frequency network for ATSC mobile/handheld services. Embodiments that do not fall under the scope of the claims are useful for understanding the invention.

According to the present invention, a method for performing data frame synchronization is provided, including replacing a predetermined number of bytes to be transmitted onto a studio-transmitter link with bytes containing signalling information and transmitting the predetermined number of bytes in a transport stream over the studio-to transmitter link.

The method may further include assigning a packet identifier to a predetermined number of transport stream packets, where the packet identifier is unknown or known (*i.e.,* prestored) to a post processor on the studio-transmitter link. The method includes calculating a first checksum on the bytes containing the signalling information, and transmitting the first checksum onto the studio-transmitter link to the post-processor. If the packet identifier is unknown, upon receiving the transport stream from the studio-transmitter link, parsing is performed on the transport stream to obtain the packet identifier of each transport stream packet. In addition, searching for a predetermined number of consecutive transport stream packets having the same packet identifier, calculating a second checksum of a portion of the predetermined number of transport stream packets, comparing the first checksum and the second checksum, and extracting the signalling information if the first checksum and the second checksum are the same are performed. The signalling information obtained from the extracting is used to perform frame synchronization.

If the packet identifier has been prestored, searching for the predetermined number of transport stream packets having the packet identifier prestored in the memory is performed. In turn, calculating a second checksum of a portion of the predetermined number of transport stream packets, comparing the first checksum and the second checksum, and extracting the signalling information if the first checksum and the second checksum are the same are performed. The signalling information obtained from the extracting is then used to perform frame synchronization.

In yet another aspect of the present invention, a system for performing data frame synchronization is provides including a group formatter and a packet transmitter. The group formatter replaces bytes to be transmitted onto a studio-transmitter link with bytes containing signalling information and the packet transmitter transmits the bytes in a transport stream over the studio-transmitter link.

A multiplexer and processor may also be provided to the system. The multiplexer assigns a packet identifier to a predetermined number of transport stream packets, the packet identifier being unknown or known (*i.e.,* prestored) to a post processor on the studio-transmitter link. A checksum calculator calculates a first checksum on the bytes containing the signalling information and the packet transmitter further transmits the first checksum onto the studio-transmitter link to the post-processor. A packet receiver receives the transport stream from the studio-transmitter link and a processor parse the transport stream to obtain the packet identifier of each transport stream packet. In the case where the packet identifier is unknown, the processor searches for a predetermined number of consecutive transport stream packets having the same packet identifier, calculates a second checksum of a portion of the predetermined number of transport stream packets, and compares the first checksum and the second checksum. The processor then extracts the signalling information if the first checksum and the second checksum are the same, and uses the signalling information obtained from said extracting to perform frame synchronization.

Further features and advantages, as well as the structure and operation, of various example embodiments of the present invention are described in detail below with reference to the accompanying drawings.

BRIEF DESCRIPTION OF THE DRAWING

The features and advantages of the example embodiments of the invention presented herein will become more apparent from the detailed description set forth below when taken in conjunction with the drawings in which like reference numbers indicate identical or functionally similar elements.

FIG.1 depicts the system core functions and enhancement tools that have been added to the A/53 standard to form the A/153 candidate standard;

FIG. 2 depicts a block diagram of an ATSC M/H transmission system;

FIG. 3 depicts the structure and individual components of an M/H Frame according to the A/153 candidate standard;

FIG. 4 depicts a mapping of received ATSC M/H packets to positions in an 8-VSB data field;

FIG. 5 depicts the system core functions and enhancement tools that have been added to the A/53 standard which results in enhanced ATSC mobile DTV, in accordance with an embodiment of the presentation invention;

FIG. 6 is a block diagram of a pre-processor and a post processor with a mechanism for inserting signalling into the TS stream over the STL in accordance with an embodiment of the present invention;

FIG. 7 depicts A/153 pre-processor architecture and where the group formatter inserts 45 dummy bytes into an MH Group. FIG. 8 depicts a pre- processor architecture and MH Frame as well as the basic dummy byte signalling syntax used to enable the alignment of MHE packets to VSB Data Fields and signal a mode in accordance with an embodiment of the present invention;

FIG. 9 illustrates a signalling syntax used in place of 13 dummy bytes in an M/H Group in accordance with an embodiment of the present invention;

FIG. 10 depicts 1 of 12 modified trellis encoders that can be set to a normal mode or an initialization mode according to the ATSC A/153 candidate standard, which are leveraged in accordance with an embodiment of the present invention;

FIG. 11 depicts the input before and output after the ATSC-52 segment continuous convolutional byte interleaver showing the select 12 packets (each having a single trellis initialization byte) to be used for ATSC M/H SFN in accordance with an embodiment of the present invention;

FIG. 12 illustrates the output of an ATSC 52-segment continuous convolutional byte interleaver and a timing diagram showing the instant each 1 of 12 initialization bytes enters 1 of 12 trellis encoders and the initialization mode is active for two symbol clock cycles or 4 bits of symbol data, in accordance with an embodiment of the present invention;

FIG. 13 depicts mapping of a VSB synchronization packet to a VSB frame in an ATSC SFN (i.e., without mobile data) in accordance with an embodiment of the present invention;

FIG. 14 depicts a memory map of an ATSC 52-segment continuous convolutional byte interleaver showing time dispersion of inserted VSB synchronization packet ("VSP") which has some fixed byte syntax locations in ATSC SFN (i.e., without mobile data) in accordance with an embodiment of the present invention;

FIG. 15 depicts a syntax for a VSB synchronization packet ("VSP") in ATSC SFN (i.e., without mobile data) in accordance with an embodiment of the present invention;

FIG. 16 depicts two flowcharts showing processes for transitioning between normal ATSC SFN (i.e., without mobile data) and ATSC SFN M/H modes in accordance with an embodiment of the present invention.

DETAILED DESCRIPTION

The example embodiments of the invention presented herein are directed to apparatus, systems, methods and computer program products for producing a single frequency network for ATSC mobile/handheld services. This is for convenience only and is not intended to limit the application of the present invention. In fact, after reading the following description, it will be apparent to one skilled in the relevant art(s) how to implement the following invention in alternative embodiments (e.g., single transmitter or multi-frequency networks).

**I. General Overview**

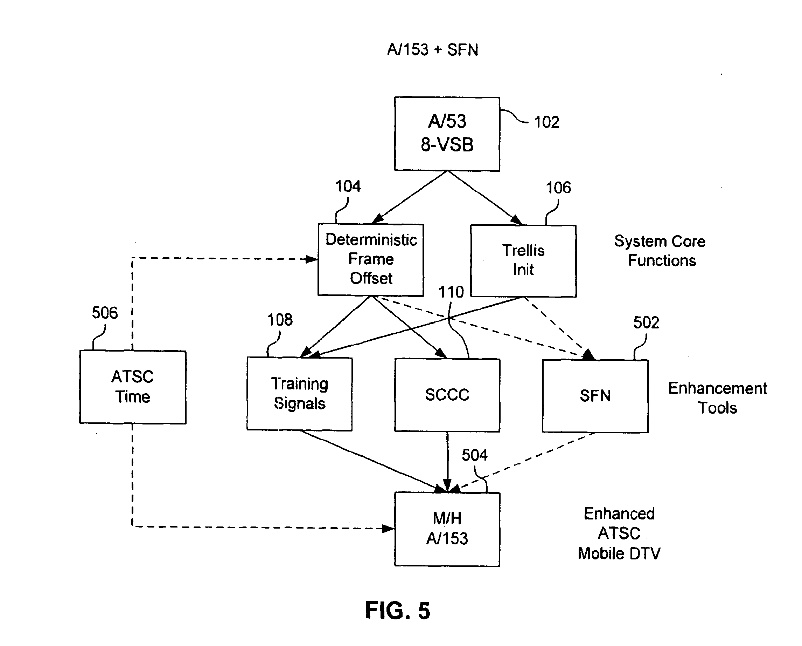

FIG. 5 depicts the system core functions and enhancement tools that have been added to the A/53 standard which results in an enhanced ATSC mobile DTV standard 504. As shown in FIG. 5, the core functions of deterministic frame offset and trellis initialization have been leverage for the mechanisms for providing SFN 502. Some new ATSC Time 506 enhancement tools are shown coupled with the existing ATSC A/153 candidate standard. Generally, example aspects of the present invention describe mechanisms for synchronizing MHE packets with VSB data frames and the synchronizing of trellis coders in an ATSC M/H DTV system in either an SFN or non-SFN environment. ATSC Time 506, which is applicable for data frame alignment, is described in U.S. Pat. Appln. No. 2/024,238, publication number US 2008/211969 A1.

**II. ATSC M/H Transmission System**

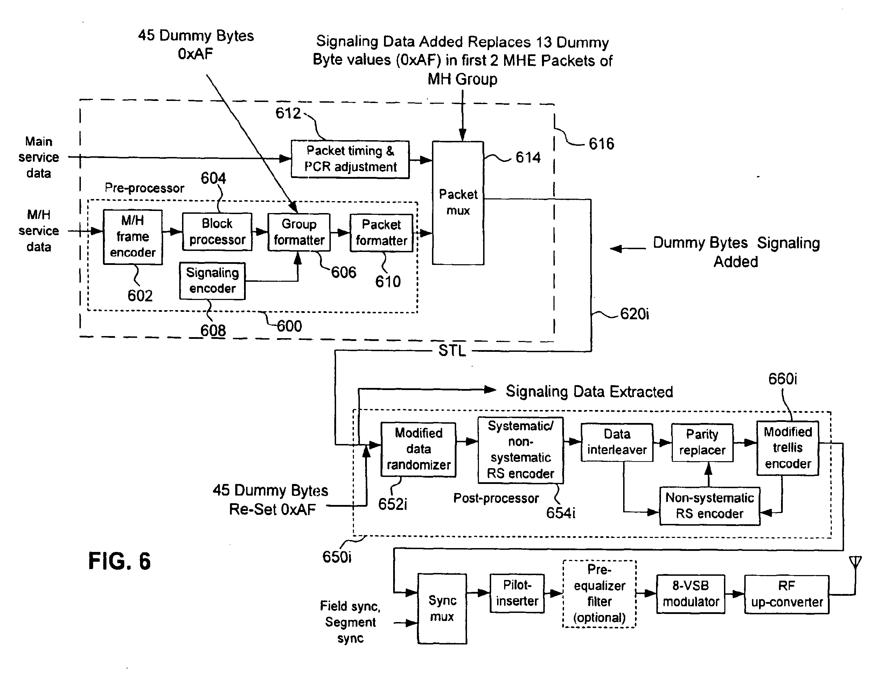

FIG. 6 is a block diagram of an ATSC M/H transmission system including a pre-processor 600 (also referred to interchangeably as an "M/H multiplexer") and a post processor $650_1$, $650_2$, ..., $650_i$, $650_n$. In the head-end 616, pre-processor 600 includes an M/H Frame encoder 602, a block processor 604, a group formatter 606, a signalling encoder 608, and a packet formatter 610. M/H Frame encoder 602 receives M/H service data and constructs RS/ CRC Frames from the M/H service data. Block processor 604, in turn, performs an outer Serial Concatenated Convolution Code (SCCC) of the coded data received from the M/H Frame encoder 602. Group formatter 606 maps the FEC coded M/H service data received from block processor 604 into corresponding M/H blocks of an M/H Group, along with pre-determined training data bytes, PCCC-encoded signalling data, and data bytes to be used for initializing the trellis encoder memories. Group formatter 606 also inserts placeholder bytes for main service data, MPEG-2 headers, non-systematic RS parity, and dummy data bytes to complete construction of the intended group format. A packet formatter 610 then processes and formats the bytes of data output by group formatter 606 and completes creation of the MHE packets. PCR adjustment unit 612 performs packet timing and PCR adjustment. A consecutively positioned packet multiplexer 614, in turn, multiplexes the normal TS data fed by packet timing and PCR adjustment unit 612 with M HE TS data packets fed by packet formatter 610.

**III. M/H Data Frame Synchronization Using Dummy Bytes**

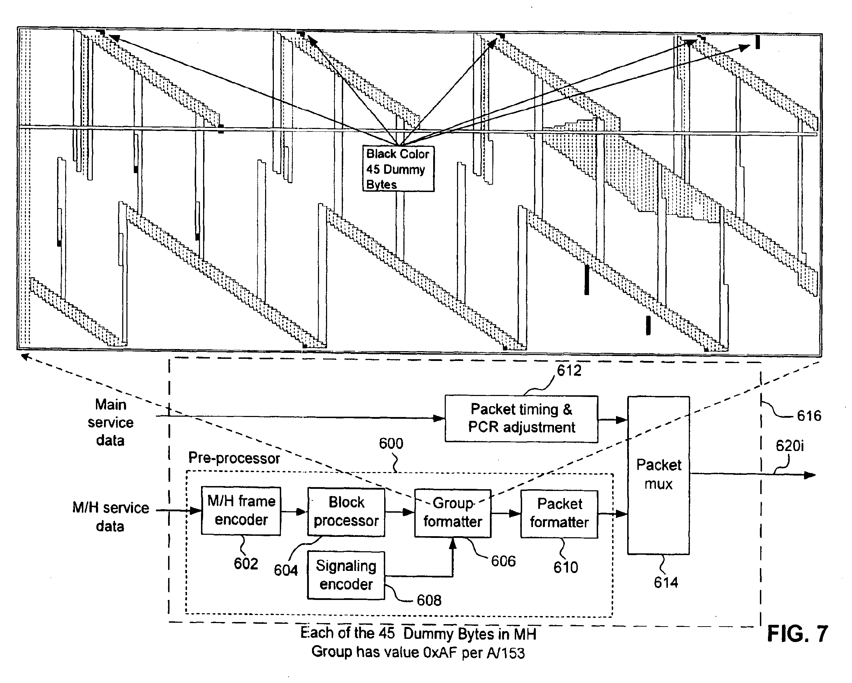

FIG. 7 depicts the architecture of a pre-processor 600 described above with respect to FIG. 6 as well as a mapping showing locations populated by dummy bytes. Group formatter 606, normally fills the M/H Frame with 45 dummy data bytes each in a known location and having a value of 0xAF per the A/153 candidate standard to complete the M/H Group structure. Thirteen (13) of these dummy bytes from the first two (2) MHE packets of a MH Group will be replaced with a new signalling syntax in the packet multiplexer 614. Referring to both FIGs. 6 and 7, the new dummy byte syntax is transmitted from packet multiplexer 614 over the STL $620_1$, $620_2$, ..., $620_i$, $620_n$ to the post-processor $650_i$ in part to signal MH framing in the post-processor $650_1$, $650_2$, ..., $650_i$, $650_n$ (*e.g.,* exciter). Post-processor $650_1$, $650_2$, ..., $650_i$, $650_n$ extracts the signalling data and replaces the fields holding this data with dummy bytes with the normal value 0xAF per the A/153 candidate standard. Hence, a point to point signalling channel between the pre-processor 600 and post-processor $650_1$, $650_2$, ..., $650_i$, $650_n$ over the STL $620_1$, $620_2$, ..., $620_i$, $620_n$ is established using thirteen (13) of forty-five (45) dummy bytes. For more signalling capacity the dummy bytes # 14-45 can be used for future extensibility.

The first twelve (12) dummy bytes transfer signalling information and the 13th dummy byte transfers a cyclic-redundancy-check ("CRC") checksum calculated over the preceding 96 bits of signalling information for security and verification purposes. In an example embodiment, the CRC check is an 8-bit CRC checksum, but another redundancy check algorithm can be used instead.

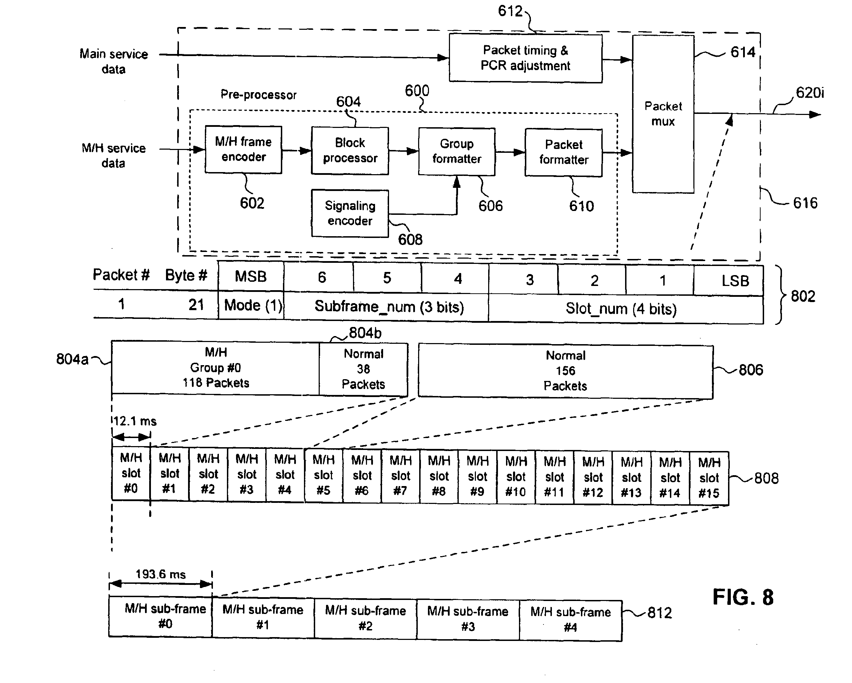

FIG. 8 depicts the pre-processor architecture 600 described above with respect to FIGs. 6 and 7 as well as the minimum dummy byte syntax 802 needed for MH Frame synchronization. As shown in FIG. 8, packet multiplexer 614 creates five (5) M/H Sub-Frames 812. Each sub-frame contains sixteen (16) slots 808 of 156 TS data packets where each TS data packet has 188 bytes. An M/H Slot may contain 118 data MHE packets with data for M/H receivers (*i.e.,* "M/H Group") 804a and 38 data packets of normal data for stationary receivers (*i.e.,* "normal 38 packets") 804b, collectively 804. Alternatively, a data slot may contain 156 data packets of normal data only (*i.e.,* "normal 156 packets" with data for stationary or "main stream" receivers) 806. Every M/H Group consists of 118 consecutive MHE packets and is formed and assigned the same thirteen (13) bit packet identifier (PID) value by packet formatter 610 located immediately before packet multiplexer 614 in pre-processor 600. The PID value may be a reserved value known to both pre-processor 600 and post-processor $650_1$, $650_2$, ..., $650_i$, $650_n$ in advance. According to the invention, the PID value may be a value known only to pre-processor 600, which is discovered and verified by an algorithm in post-processor $650_1$, $650_2$, ..., $650_i$, $650_n$.

To start the MH Frame synchronization process, the exciter parses the incoming transport stream received over the STL $620_1$, $620_2$, ..., $620_i$, $620_n$ looking at the PID value of every packet. If a reserved PID is in use, and known by exciter, the incoming stream is searched for the reserved PID. When 118 consecutive reserved PID values are found, this indicates discovery of a MH Group.

If the PID value used is known only to the pre-processor 600, a discovery algorithm is performed by the exciter. The exciter parses the incoming stream and looks for any PID value that is present in 118 consecutive packets in the incoming stream. Once 118 8 consecutive packets with the same PID are found, the first two (2) packets are treated as MHE packets and the CRC checksum from 13th byte is used to verify that 118 consecutive packets are truly a MH Group. If CRC checksum is correct, it means that the MH Group (and the PID being used) has been discovered and verified by the exciter.

Packet multiplexer 614 inserts signalling bits into the first two MHE packets of every MH Group in spaces normally occupied by dummy bytes. Once the exciter post processor $650_1$, $650_2$,..., $650_i$, $650_n$ discovers and verifies the MH Group, the signalling syntax 802 carried in the twelve (12) dummy byte positions is used. In one embodiment, before the signalling data carried in the MHE packets reaches data randomizer $652_1$, $652_2$,..., $652_i$, $652_n$, a processor (or other control logic) extracts the signalling data and resets the corresponding fields with dummy bytes (*e.g.,* resets the element values to a value of 0xAF (hex)).

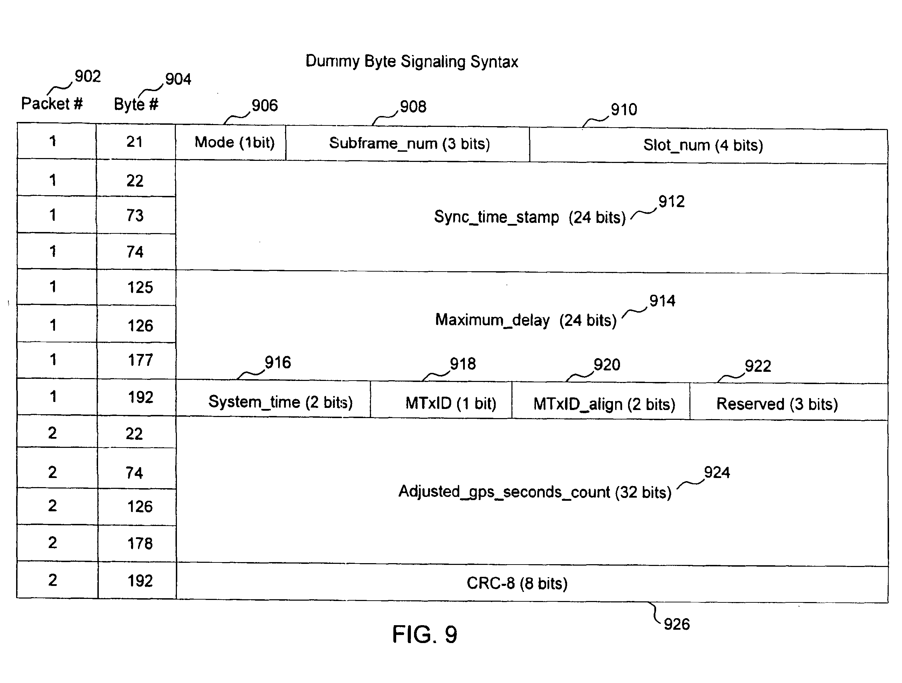

The first thirteen (13) dummy bytes of an M/H Group are thus modified to create a point to point signalling channel. FIG. 8 shows a portion of syntax 802 used to signal to the exciter for MH frame synchronization. The full syntax with signalling for SFN Timing, etc., is shown for corresponding packet/byte pairs (902/904) in more detail in FIG. 9. The signalling information is carried in the first two (2) MHE packets of an ATSC M/H Group, and includes the following syntax and semantics:

Mode (1 bit) 906: indicates control information for switching exciters from a first operation mode, in which data for both stationary and mobile receivers are transmitted, to a second operation mode, in which only data for stationary receivers are transmitted. When in ATSC SFN M/H mode, this mode bit is used to signal a mode change from ATSC SFN M/H mode to normal ATSC SFN mode (i.e. no mobile data). In an example embodiment, the Mode field 906 is set to '0' only during the last M/H Frame before the M/H mode ends, otherwise it is set to '1'. This allows the head end (e.g., from M/H multiplexer 614) to signal the exciter that the next M/H Frame will begin an ATSC SFN normal mode. This also signals the appearance of a VSB synchronization packet (VSP) in the next M/H Frame to be used for VSB framing and trellis initialization for SFN operation in normal ATSC SFN mode. The exciter will also set the enhanced mode bits in the Data Field Sync ("DFS") signal that the normal ATSC mode is being used.

subframe_number (3 bits) 908: Provides implicit signalling of a MH sub-frame number, indicating the current sub-frame number (0-4) within the M/H Frame carrying these signalling bits.

slot_number (4 bits) 910: Provides implicit signalling of MH slot number indicating the number of the current slot (0-15) within the M/H Sub-Frames carrying these signalling bits.

By signalling the current sub-frame number (0-4) and slot number (0-15) the post-processor $650_1$, $650_2$, ..., $650_i$, $650_n$ can align the MHE packets to proper VSB data field with the proper offset described above with respect to FIG. 4, thus making MH frame synchronization possible. MH frame synchronization for this enhanced SFN 502 is shown in FIG. 5 by the dashed arrow pointing from deterministic frame offset 104 towards SFN 502.

sync_time_stamp (24 bits unsigned) 912: In an SFN, this value indicates the elapsed time, measured in 100ns increments, between a 1-second tick of a GPS seconds reference clock and the release from an M/H multiplexer of the first bit of a M/H encapsulation ("MHE") packet into the distribution network (*i.e.,* STL). This time stamp is compared with a local GPS reference at the exciter to enable the actual path time delay through the STL to be calculated. The result is then used in part to set size of FIFO buffer in the exciter.

max_delay (24 bits) 914: A value that is selected to be larger than the longest path delay in the distribution network (STL) to all exciters in a SFN and indicates a delay value from 0 to 1 second in 100 nanosecond increments. This value is used with the calculated path time delay through STL at site to set the size of FIFO buffer in each exciter individually in SFN. By using the following equation:

$$\text{max delay (ns):} \ \text{STL path delay (ns)} = \text{size FIFO buffer (ns)} \qquad (1)$$

This enables the same TS packets to be sent over the STL and be removed from the FIFO at the same time independent of the different time delays experienced by the packets over STL to each transmitter in SFN.

It should be understood that the time references described above at headend needed for SFN can be derived from a GPS receiver 1PPS or alternatively by an NTP (network time protocol) from an NTP server as described in German Patent Appln. DE102008031796.9, publication number DE 102008056703 A1.

System_time (2 bits) 916: indicates the status of ATSC system time (more commonly referred to as "ATSC Time") described in U.S. Patent Appln. No. 12/024,238, publication number US 2008/211969 A1. When set to '11', ATSC Time is not active. When set to '00', ATSC Time is active and a release of M/H Frame is in cadence with a GPS/ATSC Epoch. When set to '01', ATSC Time is active and adjusted_GPS_seconds_count is used to send the GPS seconds count to an exciter. When set to '10', ATSC Time is active and the GPS (seconds) count is available at the exciter and therefore adjusted_GPS_seconds_count is not sent.

MTxID (1 bit) 918: when set to '1', the MTxID is On; when set to '0', MTxID is Off.

MTxID_MH_Frame_Align (2 bits) 920: a counter (started at '00' at Epoch) that cycles (00,01,10,11) and indicates a known offset of MTxID to the start of a M/H Frame. When MTxID_MH_Frame_Align is equal to '00', it indicates that MTxID and the M/H Frame have the same alignment at Epoch; all other counts have a known offset. This enables exciter to start MTxID with a correct phase relative to a start of M/H Frame.

An MTxID data block contains 32 fields and an M/H Frame contains 40 fields. A starting offset needs to be calculated from an epoch and signaled to an exciter which in turn inserts the MTxID in the correct phase.

Reserved (3 bits) 922: all reserved bits set to '1'.

adjusted_gps_seconds_count (32-bit unsigned integer) 924: This field preferably contains the value of the globally available GPS seconds count, at the instant of release of the first MHE packet from M/H multiplexer 600. When the sum of the values of the synchronization_time_stamp and maximum_delay is less than 10,000,000 the current value of globally available GPS seconds count is sent in MHE packet. When the sum is greater than 10,000,000, the currently available GPS seconds count shall be incremented by one (+I) before sending in MHE packet. This is only used in ATSC Time when a GPS seconds count is not available at the exciter.

CRC-8 (8 bits) 926: a CRC-8 calculated over all 96 preceding bits of dummy byte signalling data.

### IV. M/H Deterministic Trellis Initialization (SFN)

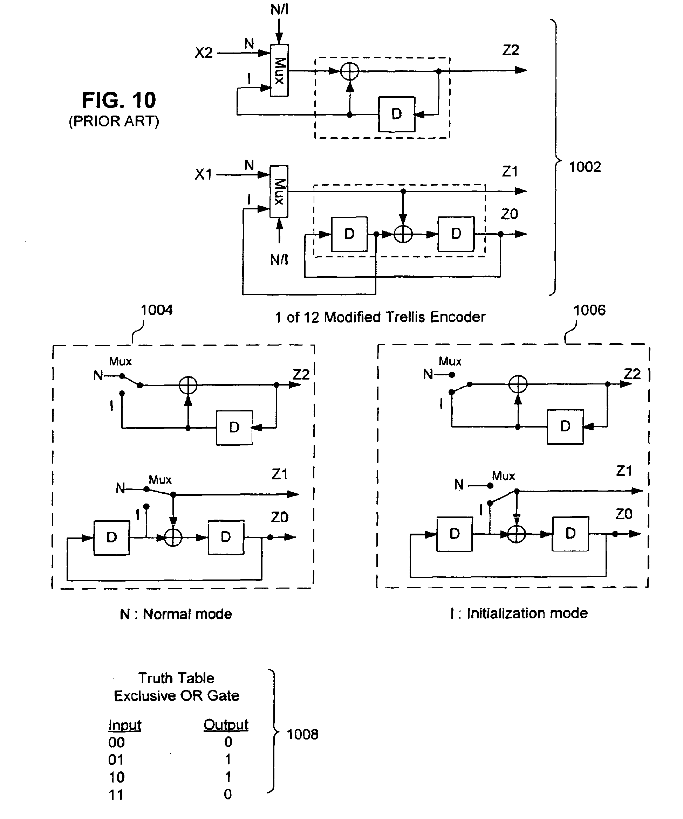

FIG. 10 depicts I of 12 modified trellis encoders 1002. Each encoder includes a multiplexer to switch between a normal ("N") input mode 1004 and an initialization ("I") input mode 1006 which is fed back from the delay devices within the trellis encoder. A normal/initialization control input to the multiplexer is used to select the initialization input path when initialization is required. Particularly, the normal/initialization control input selects the initialization path during the leading 2-symbol interval (4 bits) of each respective (1 of 12) trellis initialization bytes to synchronize (1 of 12) respective trellis codes to a zero state. This permits pre-calculated training signal (FIG. 5, 108) data values to be inserted into the trellis encoder immediately after trellis initialization, resulting in known and repeatable training signal symbol sequences being produced by the modified trellis encoders. The multiplexer selects the normal path at all other times. The trellis initialization circuit shown in 1002 can also be used to enable synchronization of all trellis encoders in all exciters to support creating an SFN, as illustrated in FIG. 5 by a dashed arrow pointing from trellis initialization 106 towards SFN 502.

The use of the basic core function trellis initialization 106, for producing coherent symbols from multiple exciters in digital RF transmitters (i.e., in an SFN), will now be described. Referring again to FIG. 10, with the Mux of a trellis encoder in the initialization mode 1006, both inputs of the exclusive OR (XOR) gates are forced to the same logic value, particularly a logic zero (0) output from XOR independent of logic input, as shown in the XOR truth table 1008. Since the two D memory latches are in series in the Z0 path, two symbol clock cycles are required to initialize the state of trellis encoders. Thus, to initialize the three D memory latches all to a common zero (0) state, the initialization line ("I") on multiplexer is enabled for two symbol clock periods. This occurs as the first 4 bits (i.e., 2 + 2) from each initialization byte first enter the respective trellis encoder as will be explained. This forces both inputs of the exclusive OR gate to a common logic level to produces a zero (0) output independent of the current state. All three D memory latches will assume a zero (0) output state after two symbol clock periods in initialization mode.

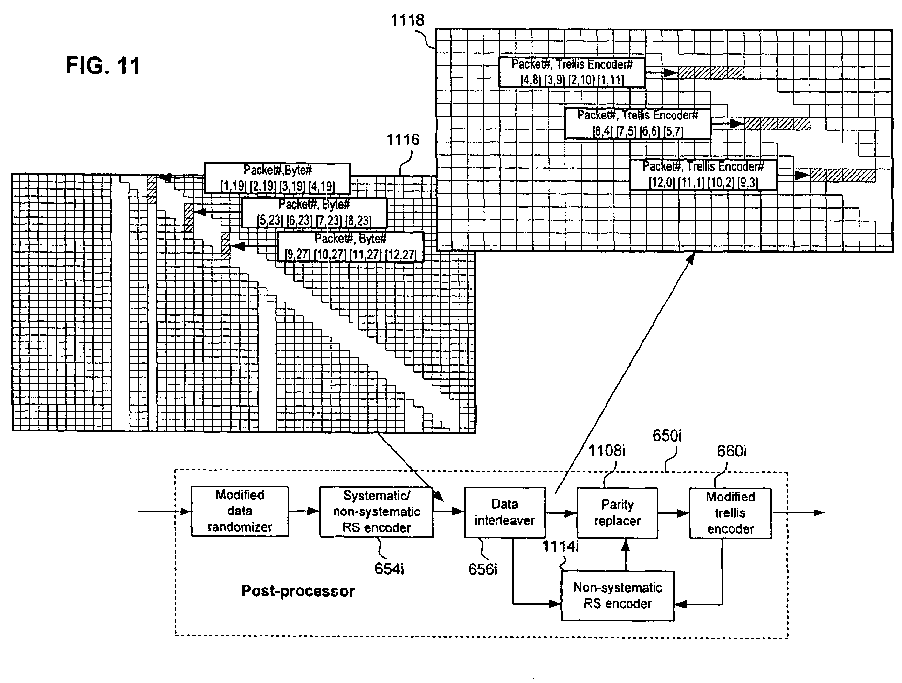

Selection of the 12 trellis initialization bytes which will be used for MH SFN will now be described with reference to FIGs. 6 and 11. FIG. 11 depicts the post-processor $650_1$, $650_2$, ..., $650_i$,..., $650_n$ in the MH exciter, when a 118 MHE packet (MH Group) is processed by the non-systematic RS encoder. Twenty (20) non-systematic RS parity bytes are generated for each MHE packet and placed in pre-determined locations within the MHE packet defined by the A/153 candidate standard. The MHE packet payload data (i.e., mobile data) is of no use to a normal ATSC receiver. Thus, a PID assigned the MHE packet is not recognized as a normal ATSC service and the MHE packets are simply ignored by an ATSC receiver. This ensures legacy backward compatibility. The output of the non-systematic RS encoder $654_1$, $654_2$, ..., $654_i$,.... $654_n$, before the data interleaver $656_1$, $656_2$,..., $656_i$,..., $656_n$, mapping is shown in 1116 with the twelve (12) MHE packet/byte pairs selected (e.g., 1/19,2/19,3/19,4/19,5/23,6,23,7/23,8/23,9/27,10/27,11/27,12/27) for SFN trellis initialization. Each select byte from a packet/byte pair has been identified *a priori* before data interleaver $656_1$, $656_2$,..., $656_i$,..., $656_n$ and will enter a respective (1 of 12) trellis encoder $660_1$, $660_2$, ..., $660_i$,..., $660_n$ as shown in mapping 1118 later in the post processing, at which time trellis initialization is conducted on the first 4 bits of each initialization byte shown in mapping 1116. With the Mux of trellis encoder $660_1$, $660_2$, ..., $660_i$,..., $660_n$ in the initialization mode, both inputs of the exclusive OR (XOR) gates are forced to the same logic value this produces a logic zero (0) output from XOR independent of logic input as shown in logic table 1008 (FIG. 10). To initialize the three D memory latches to a common zero (0) state, the initialization line ("1") on multiplexer is enabled for two symbol clock periods. This occurs on the first 4 bits (2 bits per symbol) from each initialization byte as they enter a respective trellis encoder.

This trellis initialization causes all trellis encoder states to be set to the same zero state at the same time, in each exciter in the SFN network. This will then produce coherent symbols from all transmitters (given the VSB Data Frames are synchronized and all exciters are receiving the same data stream over the STL), which is a requirement for an SFN.

The twelve (12) trellis initialization bytes selected are non-systematic RS parity bytes from twelve (12) MHE packets. Using a RS parity byte for trellis initialization reduces the number of non-systematic RS parity bytes from 20 to 19 (i.e., I byte is used trellis initialization) only over these twelve (12) MHE packets of MH Group #0, sub-frame #0, slot #0 once per MH frame (every 12,480 packets). This will cause a very small reduction of approximately 0.2 dB in RS error correction capability for just these 12 MHE packets alone approximately once per second. As described above, these and all MHE packets are discarded by legacy ATSC receivers (not shown). The non systematic RS parity is not used by MH mobile receivers. Thus, the reduction of parity bytes will not materially effect mobile services.

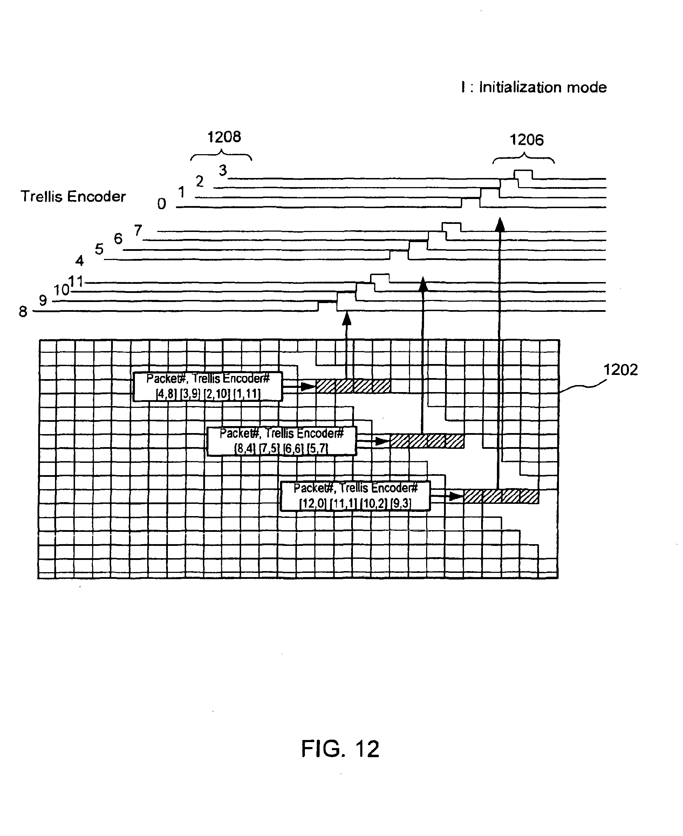

FIG. 12 illustrates exemplary initialization of trellis encoders 0-11 (1208) according to an embodiment of the present invention. As shown in FIG. 12, twelve initialization bytes shown in mapping 1202 are activated upon by a rising edge of the initialization ("I") mode control signal 1206 as each initialization byte enters a respective (1 of 12) trellis encoder $660_1$, $660_2$,..., $660_i$,..., $660_n$ as described above with respect to FIGs. 10 and 11.

## V. Normal Mode VSB Frame Synchronization (SFN)

When a station is operating with ATSC A/153 MH content in an SFN, the dummy byte signalling (i.e., VSB Frame Synchronization) and non-systematic RS parity bytes (trellis initialization) as described above are used to establish and maintain the synchronization in SFN. However, if a station desires to stop transmission of all MH mobile content (i.e., returns to normal A/53 mode) maintaining SFN in normal mode, a different mechanism in accordance with an embodiment of the present invention, is used. This aspect of the present invention is used because the dummy bytes and non-systematic RS parity bytes are only available when the station is broadcasting ATSC A/153 MH data.

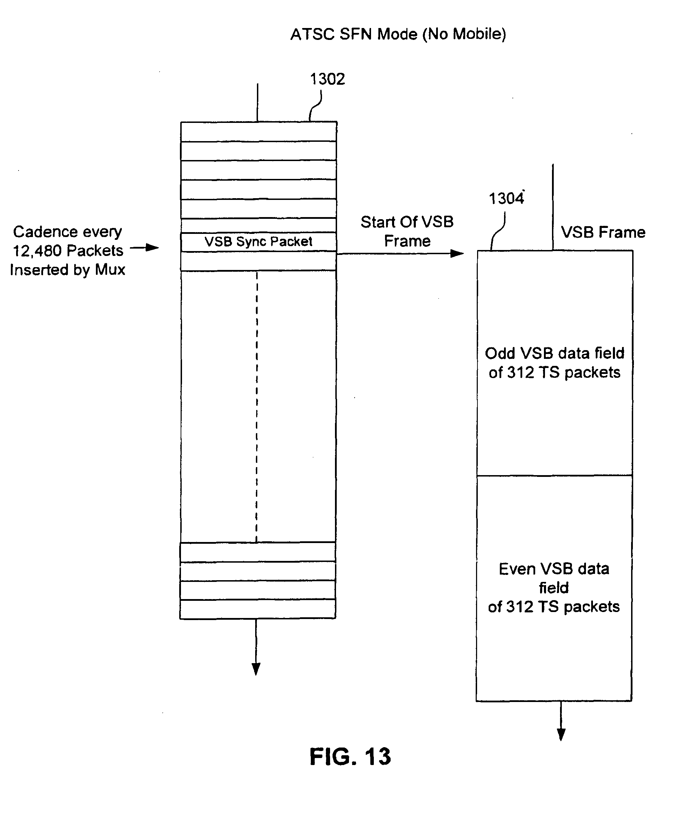

FIG. 13 depicts the mapping of a VSB synchronization packet ("VSP") 1302 sent over an STL to a A/53 VSB frame 1304 generated in the exciter in accordance with an embodiment of the present invention. In one embodiment, shown in FIG. 13, a VSP is transmitted to all exciters in the SFN once every 12,480 packets, which defines the cadence (*i.e,* 20 VSB frames exactly equal to the length of a MH frame). In this example, a single VSP is sent as the last packet of the 12,480 packet cadence and its appearance in TS defines the start of a VSB frame, as shown in FIG. 13. Preferably, the first packet after the VSP will be mapped as the first packet of an odd VSB data field. Thus, the cadence is the same in both MH SFN mode and normal SFN mode, which improves the switching between modes. The VSP also can be locked to an ATSC system time epoch.

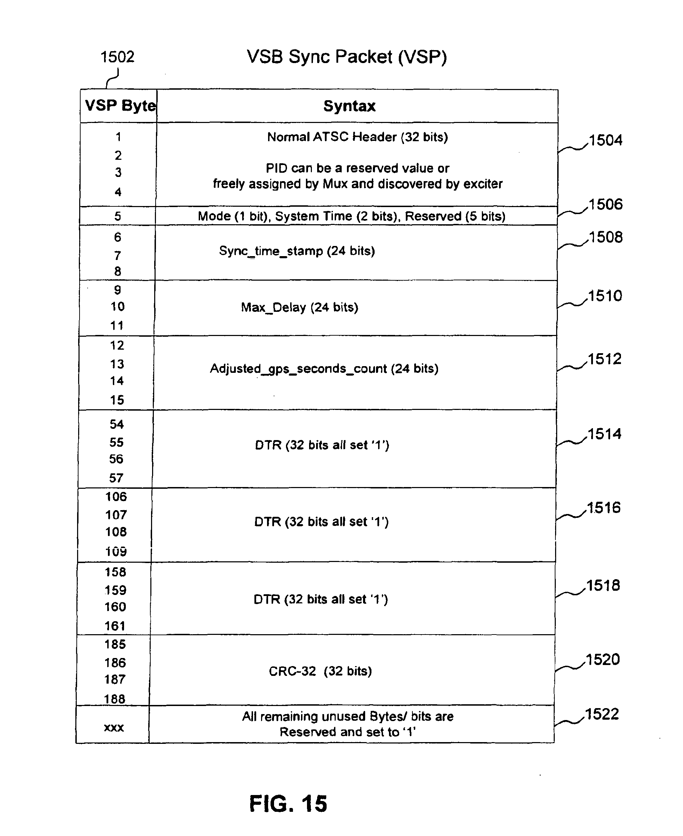

Referring briefly to FIG. 15 the syntax of a VSP is illustrated. As shown in FIG. 15, a VSP includes a packet identifier ("PID") 1504. In accordance with an example embodiment of the present invention, PID 1504 is used to identify a VSP in the transport stream. The PID value can be identified by using a reserved PID value which is known between MH multiplexer at studio and exciter. Alternatively, the PID value can be a null packet (e.g., 0x I FFF) or any undefined PID. The discovery algorithm and verification methods for both cases is described below.

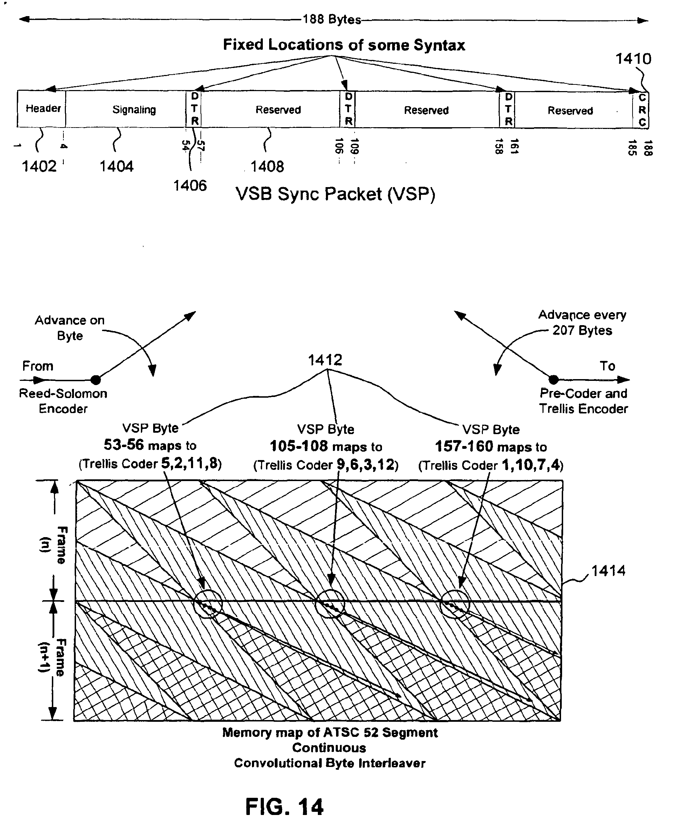

FIG. 14 depicts a memory map of an ATSC 52-segment continuous convolutional byte interleaver 1414 showing the time dispersion of VSB synchronization packet ("VSP"). As shown in FIG. 14, a VSP 1408 contains a header 1402 followed by signalling data 1404. The header section 1402 contains a 13 bit VSP PID. If a reserved PID is used, the exciter will discover this by parsing the incoming TS sent over STL until it finds the reserved PID value in a packet. In an example embodiment, the reserved PID value is sent once every 12,480 packets.

Once the reserved PID value has been located within the TS, the exciter calculates the CRC 32 checksum 1410 carried at the end of the received packet to verify that it is a VSP. The exciter will then find the VSP PID value once every 12,480 packets because the MH multiplexer is generating this cadence which the exciter then slaves to. As described above with regard to FIG. 13, the VSP is then aligned 1304 and the next packet following the VSP will start an odd VSB data field.

If a Null packet or an undefined PID value is used for a VSP, these can appear multiple times in a 12,480 packet cadence. To discover the PID value, the exciter parses every incoming packet and calculates the CRC32 checksum assumed to be carried in last four (4) bytes of all packets. When the Checksum is found to be correct this indicates this is the VSP. The exciter will then find this VSP PID value every 12,480 packets and the CRC32 checksum is checked and found to be correct. This gives confidence the exciter is synchronized with cadence. As described above with regard to FIG. 13, the VSP is then aligned 1304 and the next packet following VSP will start an odd VSB data field. The undefined PID or Null packet may occur several times during cadence interval, but will have VSP Syntax only every 12,480 packets. Either of the above VSP discovery methods may be used to provide more system flexibility in operation.

## VI. Normal Mode Determinisitc Trellis Reset or Initialization (SFN)

In normal mode SFN it is also necessary to synchronize the trellis encoder memories of all exciters in a SFN to a common zero state at specific points in time in  the data stream simultaneously by all exciters in a SFN. In another embodiment, a deterministic trellis reset (DTR) or initialization byte is used to perform trellis encoder synchronization. The VSP 1408 has twelve (12) pre-determined byte (DTR) positions 1406. Each byte will be used to initialize (1 of 12) trellis encoders when the byte first enters the respective (1 of 12) trellis encoder.

Trellis encoder synchronization is accomplished based on *a priori* knowledge of the location of the interleaved VSP packet DTR bytes at the output of data byte interleaver before the trellis encoder stage. With the knowledge of the time dispersion of VSP at the output of the ATSC interleaver (once the data frame synchronization data has been achieved and the same data is being sent over STL to all exciters), twelve (12) predetermined byte positions 1406 in VSP are identified and used to trigger a DTR or initialization in each of the twelve trellis encoders in all of the exciters in the SFN. The initialization occurs as soon as each of these deterministically assigned bytes enters its designated trellis encoder. This will then cause Coherent symbols to be produced from all transmitters in the SFN.

The diagonal arrows in FIG. 14 shows the time dispersed positions assumed by bytes of the VSP 1412 in the interleaver. The four (4) bytes selected and marked (DTR) on each of the three diagonal sections show that these fixed position VSP bytes 53-56, 105-108, 157-160 will each be delivered deterministically to one of the twelve (12) trellis coders numbered 5, 2, 11, 8; 9, 6, 3, 12; 1, 10, 7, 4, respectively, when they exit the interleaver memory. This allows the timing in the exciter to be designed to enable a deterministic trellis initialization 1006 to a zero state to occur over the first 4 bits of each DTR or initialization byte when each byte first enters the respective 1 of 12 trellis encoder.

This initialization will occur in a serial fashion over four (4) segments in every exciter and effectively synchronizes all twelve (12) trellis coders in all exciters in a deterministic fashion. Twelve (12) RS parity errors will occur on every VSP by the action of the trellis initialization on the twelve designated DTR bytes. This will not affect any packet carrying normal content. The VSP, which is identified as a reserved or undefined PID is not used for any purpose by normal ATSC receivers and will be ignored. As used for purpose of SFN the parity errors generated by trellis Initialization function 1006 are not corrected by RS parity re-encoding $1114_1$, $1114_2$, ..., $1114_i$, $1114_n$ and parity replacer $1108_1$, $1108_2$, ..., $1108_i$, $1108_n$ as is described in the A/153 candidate standard when trellis initialization is used for purpose of generating known training signals.

FIG. 15 depicts the syntax for a VSB synchronization packet ("VSP"), in accordance with an embodiment of the present invention. The normal ATSC header 1504 has a thirteen (13) bit packet identifier (PID) which can be a reserved PID value, or an undefined freely assigned PID value that is assigned by the M/H multiplexer and sent over an STL and discovered downstream in an exciter. In addition to the normal ATSC header 1504 the VSP includes the following syntax and semantics:

The Mode (1 bit), System Time (2 bits), and Reserved (5 bits) fields 1506 have the following semantics:

Mode: used to signal a mode change from normal ATSC mode to ATSC M/H mode. In one example embodiment, the mode bit is set to '0' only during the last two (2) (Two) VSPs before the normal mode ends; otherwise it is set to '1'. The M/H service multiplexer at the head-end provides signalling to an exciter that a transition to ATSC M/H mode will begin. This signalling also indicates that 118 consecutive MHE packets used for VSB Framing and trellis initialization for SFN operation in ATSC M/H mode will soon appear. In addition, this signalling also causes the exciter to set enhanced mode bits in a Data Field Sync to signal to receivers that the mode is ATSC M/H.

System_time (2 bits): indicates the status of ATSC Time described in U.S. Patent Appln. No. 12/024,238, publication number US 2008/211969 A1. When set to '11', ATSC Time is not active. When set to '00', ATSC Time is active. When set to '01' ATSC Time is active and adjusted_GPS_seconds_count is used to send the GPS seconds count to an exciter. When set to '10', ATSC Time is active and the GPS Seconds count is available at exciter in which case adjusted_GPS_seconds_count is not sent.

Reserved (5 bits): remaining bits are reserved and set to '1'.

sync_time_stamp (24 bit unsigned integer) 1508: a field that indicates the elapsed time, measured in 100ns increments, between a 1-second tick of the GPS (seconds) reference clock and the release from the M/H multiplexer ( of the first bit of VSP Packet into the distribution network (i.e., STL).

max_delay (24 bit) 1510: a value that is selected to be larger than the longest STL delay path in the distribution network and indicates a delay from 0 to 1 sec in 100ns increments.

adjusted_gps_seconds_count (32-bit unsigned integer) 1512: a field that shall contain the value of the globally available GPS seconds count at the instant of release of VSP packet from M/H multiplexer 600. When the sum of the values of the synchronization_time_stamp and maximium_delay fields in 100ns increments is less than 10,000,000 (or I second) the current value of globally available GPS seconds count is sent in VSP packet. When the sum is greater than 10,000,000 the currently available GPS seconds count shall be incremented by one (+1) before sending it in a VSP. This is only used in ATSC Time when a GPS seconds count is not available at the exciter.

DTR (32-bits) 1514-1518: provide a deterministic trellis reset (DTR) or initialization bits used to perform trellis encoder synchronization. In a preferred embodiment, these bits are set to '1'.

CRC_32 (32 bits) 1520: the CRC checksum is calculated over all VSP bytes other than the DTR and is placed at the end of the VSP. When the exciter receives the VSP it calculates a CRC-32 checksum in same manner and compares with CRC-32 in VSP. If the values are the same this verifies no data errors have occurred and this is a VSP. If the checksum do not match an error in data has occurred or this is not a VSP. In a preferred embodiment, the remaining unused bytes/bits 1522 are reserved and set to '1'.

It is immaterial where the above signalling is carried within a VSP. Accordingly, it should be understood that the above syntax can be carried in various locations and still be within the scope of the present invention.

### VII. Switching between ATSC Modes in SFN

During ATSC A/153M/H (Mobile) operation, a broadcaster may want to switch the M/H mode off and operate in normal ATSC A/53 mode (i.e., no mobile data), while maintaining the SFN. Accordingly, mode switching under SFN operation must be supported. As explained above with reference to the MHE and VSP syntax, a mode element signals a mode change.

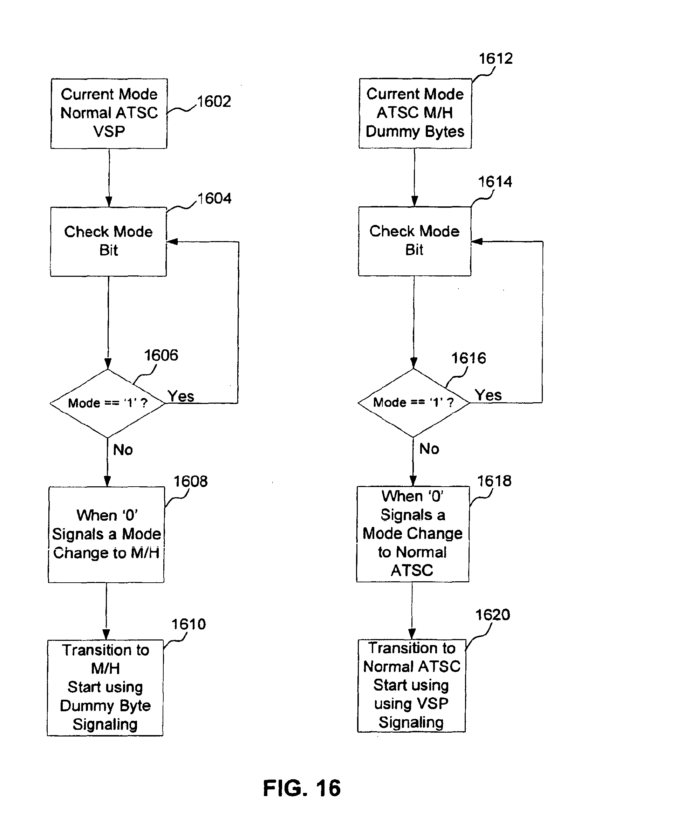

FIG. 16 depicts two flowcharts showing processes for transitioning between modes, particularly from a normal ATSC mode without M/H services using the VSP for SFN synchronization to an ATSC mode with M/H services using the MHE packets and non-systematic RS parity bytes for SFN synchronization, and vice versa. As shown in block 1602, the current mode is the normal ATSC mode, which uses VSP to provide SFN synchronization. In block 1604, the Mode bit is checked by the exciter to determine whether it has been set to '0' to signal a mode change from normal ATSC mode to ATSC M/H mode.

If the Mode bit is set to '0', this signals to the exciter that the next 20 VSB Frames will correspond to the ATSC M/H mode and that MHE packets that are used for SFN operation in ATSC M/H mode will soon appear. If a determination is made at block 1606 that the Mode bit is set to '1', then it will loop back to block 1604. However, if a determination is made at block 1606 that the Mode bit is set to '0', then block 1608 signals this to the exciter that the next M/H Frame will correspond to the ATSC M/H mode and that MHE packets that are used for signalling and VSB framing and non-systematic RS parity bytes will be used for trellis initialization for SFN operation in ATSC M/H mode will begin. It also signals to the exciter to set enhanced mode bits in a Data Field Sync to signal to receivers that the mode is ATSC M/H mode. As shown in block 1610, the exciter is now prepared to transition to ATSC M/H mode and use dummy byte signalling.

When switching from an SFN ATSC M/H mode to a SFN normal ATSC mode (i.e., no M/H services), the syntax including dummy bytes will cease to exist. Block 1612 illustrates that the current mode is the ATSC M/H mode, which uses dummy bytes to provide frame synchronization. Block 1614 checks the Mode bit to determine whether it has been set to '0' to signal a mode change from ATSC M/H mode to normal ATSC mode. If the Mode bit in the last M/H Frame before the M/H mode ends is set to '0', this signals to the exciter that the next 20 VSB Frames will correspond to the ATSC normal mode and that a VSP will appear for VSP framing and trellis initialization for SFN operation in ATSC normal mode. This also signals an exciter to set the enhanced mode bits in a Data Field Sync to signal normal ATSC mode to receivers. Accordingly, block 1616 makes a determination if the Mode bit is '1'. If so, then the process loops back to block 1614 indicating that the mode is still in ATSC M/H mode. If, however, block 1616 makes a determination that the Mode bit is '0', then the process proceeds to block 1618, where a signal is communicated to the exciter(s) that the mode is transitioning to the normal ATSC mode. As shown in block 1620, the exciter is now prepared to transition to normal ATSC mode and use VSP signalling which appear in TS.

The example embodiments of the invention described above, including their procedures, part(s) or function(s) thereof, may be implemented using hardware, software or a combination thereof and may be implemented in one or more computer systems or other processing systems. However, the manipulations performed by these example embodiments were often referred to in terms, such as entering, which are commonly associated with mental operations performed by a human operator. No such capability of a human operator is necessary in any of the operations described herein. Rather, the operations may be completely implemented with machine operations. Useful machines for performing the operation of the example embodiments presented herein include general purpose digital computers or similar devices.

From a hardware standpoint, components in an M/H DTV transmission system typically includes one or more components, such as one or more microprocessors, for performing the arithmetic and/or logical operations required for program execution, and storage media, such as one or more disk drives or memory cards (e.g., flash memory) for program and data storage, and a random access memory, for temporary data and program instruction storage. From a software standpoint, a processor typically includes software resident on a storage media (e.g., a disk drive or memory card), which, when executed, directs the processor in performing transmission and reception functions. The processor software may run on an operating system stored on the storage media, such as, for example, UNIX or Windows (e.g., NT, XP, Vista), Linux, and the like, and can adhere to various protocols such as the Ethernet, ATM, TCP/IP protocols and/or other connection or connectionless protocols. As is well known in the art, processors can run different operating systems, and can contain different types of software, each type devoted to a different function, such as handling and managing data/information from a particular source, or transforming data/information from one format into another format. It should thus be clear that the embodiments described herein are not to be construed as being limited for use with any particular type of server computer, and that any other suitable type of device for facilitating the exchange and storage of information may be employed instead.

Software embodiments of the example embodiments presented herein may be provided as a computer program product, or software, that may include an article of manufacture on a machine accessible or machine readable medium having instructions. The instructions on the machine accessible or machine readable medium may be used to program a computer system or other electronic device (e.g., computer-readable medium). The machine-readable medium may include, but is not limited to, floppy diskettes, optical disks, CD-ROMs, and magneto-optical disks or other type of media/machine-readable medium suitable for storing or transmitting electronic instructions. The techniques described herein are not limited to any particular software configuration. They may find applicability in any computing or processing environment. The terms "machine accessible medium", "machine readable medium" or "computer-readable medium" used herein shall include any medium that is capable of storing, encoding, or transmitting a sequence of instructions for execution by the machine and that cause the machine to perform any one of the methods described herein. Furthermore, it is common in the art to speak of software, in one form or another (e.g., program, procedure, process, application, module, unit, logic, and so on) as taking an action or causing a result. Such expressions are merely a shorthand way of stating that the execution of the software by a processing system causes the processor to perform an action to produce a result.

While various example embodiments of the present invention have been described above, it should be understood that they have been presented by way of example, and not limitation. It will be apparent to persons skilled in the relevant art(s) that various changes in form and detail can be made therein. Thus, the present invention should not be limited by any of the above described example embodiments, but should be defined only in accordance with the following claims and any element which is equivalent to an element specified in the claims.

In addition, it should be understood that the FIGs. 1-16 are presented for example purposes only. The architecture of the example embodiments presented herein is sufficiently flexible and configurable, such that it may be utilized (and navigated) in ways other than that shown in the accompanying figures.

**Claims**

**1.** A method for performing data frame synchronization of M/H data frames, comprising the steps of:

replacing a predetermined number of <u>dummy</u> bytes to be transmitted <u>from a head-end to several exciters in a single-frequency-network</u> onto a studio-to-transmitter link (620i) with a plurality of bytes containing signaling information;
assigning a packet identifier to a predetermined number of transport stream packets, the packet identifier being unknown to a post processor (650i) belonging <u>to each exciter</u> on the studio-to-transmitter link (620i);
calculating a first checksum on the plurality of bytes containing the signaling information;
transmitting the plurality of bytes and the first checksum in the predetermined number of transport stream packets over the studio-to-transmitter link (620i),
thereby creating a point-to-point communication link,
receiving the transport stream from the studio-to-transmitter link (620i);
parsing the transport stream to obtain the packet identifier of each transport stream packet;
searching for a predetermined number of consecutive transport stream packets having the same packet identifier;
calculating a second checksum of a portion of the predetermined number of transport stream packets;
comparing the first checksum and the second checksum;
extracting the signaling information if the first checksum and the second checksum are the same; and
using the signaling information obtained from said extracting to perform frame synchronization.

**2.** The method according to claim 1, further comprising:

resetting the plurality of bytes containing signaling information with dummy bytes at the post processor (650i).

**3.** The method according to claim 1,
wherein the signaling information includes a sub-frame number and a slot number.

**4.** The method according to claim 1, further comprising:

assigning a packet identifier being prestored in a memory of a post processor (650i) on the studio-to-transmitter link (620i);
calculating a first checksum on the plurality of <u>dummy</u> bytes containing the signaling information; and
transmitting the first checksum onto the studio-to-transmitter link (620i) to the post processor (650i).

**5.** The method according to claim 4, further comprising:

receiving the transport stream from the studio-to-transmitter link (620i);
parsing the transport stream to obtain the packet identifier of each transport stream packet;

searching for the predetermined number of consecutive transport stream packets prestored in the memory;
calculating a second checksum of a portion of the predetermined number of transport stream packets;
comparing the first checksum and the second checksum;
extracting the signaling information if the first checksum and the second checksum are the same; and
using the signaling information obtained from said extracting to perform frame synchronization.

6. A system for performing data frame synchronization of M/H data frames, comprising:

a group formatter (606) operable to replace a predetermined number of dummy bytes to be transmitted from a head-end to several exciters in a single-frequency-network onto a studio-to-transmitter link (620i) with a plurality of bytes containing signaling information;
a multiplexer (614) operable to assigning a packet identifier to a predetermined number of transport stream packets, the packet identifier being unknown to a post processor (650i) belonging to each exciter on the studio-to-transmitter link (620i);
a checksum calculator operable to calculate a first checksum on the plurality of bytes containing signaling information;
a packet transmitter operable to transmit the plurality of bytes in the predetermined number of transport stream packets and the first checksum over the studio-to-transmitter link (620i) to the post processor (650i),
a packet receiver operable to receive the transport stream from the studio-to-transmitter link (620i);
a parser operable to:

parse the transport stream to obtain the packet identifier of each transport stream packet,
search for a predetermined number of consecutive transport stream packets having the same packet identifier,
calculate a second checksum of a portion of the predetermined number of transport stream packets,
compare the first checksum and the second checksum,
extract the signaling information if the first checksum and the second checksum are the same, and
use the signaling information to perform frame synchronization.

7. The system according to claim 6,
wherein the plurality of bytes containing signaling information are reset with dummy bytes at the post processor.

8. The system according to claim 6,
wherein the signaling information includes a sub-frame number and a slot number.

9. The system according to claim 6, further comprising:

a multiplexer (614) operable to assign a packet identifier to a predetermined number of transport stream packets, the packet identifier being prestored in a memory of a post processor (650i) on a studio-to-transmitter link (620i);
a checksum calculator operable to calculate a first checksum on the plurality of bytes containing the signaling information; and
the packet transmitter further operable to transmitting the first checksum onto the studio-to-transmitter link (620i) to the post processor (650i).

10. The system according to claim 9, further comprising:

a packet receiver operable to receive the transport stream from the studio-to-transmitter link (620i);
a processor operable to:

parse the transport stream to obtain the packet identifier of each transport stream packet;
search for the predetermined number of consecutive transport stream packets having the same packet identifier;
calculate a second checksum of a portion of the predetermined number of transport stream packets;
compare the first checksum and the second checksum;
extract the signaling information if the first checksum and the second checksum are the same; and
use the signaling information obtained from said extracting to perform frame synchronization.

11. A computer-readable medium having stored sequences of instructions, the sequences of instructions including instructions which when executed by a computer system causes the computer system to perform:

replacing a predetermined number of <u>dummy</u> bytes to be transmitted <u>from a head-end to</u> several <u>exciters in a single-frequency-network</u> onto a studio-to-transmitter link (620i) with a plurality of bytes containing signaling information;

assigning a packet identifier to a predetermined number of transport stream packets, the packet identifier being unknown to a post processor (650i) <u>belonging to each exciter</u> on the studio-to-transmitter link (620i);

calculating a first checksum on the plurality of bytes containing the signaling information;

transmitting the plurality of bytes and the first checksum in the predetermined number of transport stream packets over the studio-to-transmitter link (620i),

receiving the transport stream from the studio-to-transmitter link (620i);

parsing the transport stream to obtain the packet identifier of each transport stream packet;

searching for a predetermined number of consecutive transport stream packets having the same packet identifier;

calculating a second checksum of a portion of the predetermined number of transport stream packets;

comparing the first checksum and the second checksum;

extracting the signaling information if the first checksum and the second checksum are the same; and

using the signaling information obtained from said extracting to perform frame synchronization of M/H data frames.

12. The computer-readable medium according to claim 11, further having stored thereon a sequences of instructions, which when executed by a computer system causes the computer system to perform:

resetting the plurality of bytes containing signaling information with dummy bytes at the post processor (650i).

13. The computer-readable medium according to claim 11, wherein the signaling information includes a sub-frame number and a slot number.

14. The computer-readable medium according to claim 11, further having stored thereon a sequences of instructions, which when executed by a computer system causes the computer system to perform:

assigning a packet identifier to a predetermined number of transport stream packets, the packet identifier being prestored in a memory of a post processor (650i) on the studio-to-transmitter link (620i);

calculating a first checksum on the plurality of <u>dummy</u> bytes containing the signaling information; and

transmitting the first checksum onto the studio-to-transmitter link (620i) to the post processor (650i).

15. The computer-readable medium according to claim 11, further having stored thereon a sequences of instructions, which when executed by a computer system causes the computer system to perform:

receiving the transport stream from the studio-to-transmitter link (620i);

parsing the transport stream to obtain the packet identifier of each transport stream packet;

searching for a predetermined number of consecutive transport stream packets having the same packet identifier;

calculating a second checksum of a portion of the predetermined number of transport stream packets;

comparing the first checksum and the second checksum;

extracting the signaling information if the first checksum and the second checksum are the same; and

using the signaling information obtained from said extracting to perform frame synchronization.

**Patentansprüche**

1. Ein Verfahren zur Durchführung einer Datenrahmensynchronisierung eines M/H-Datenrahmens, das die Verfahrensschritte enthält:

Ersetzen einer vorbestimmten Anzahl von Dummy-Bytes, die von einer Kopfstation zu mehreren Steuersendern in einem Monofrequenznetz auf einer Studio-Sender-Verbindung (620i) zu übertragen sind, mit mehreren Bytes, die Signalisierungs-Informationen enthalten;

Zuweisen eines Paket-Identifizierers einer vorbestimmten Anzahl von Transportstrompaketen, wobei der Paket-Identifizierer dem Post-Prozessor (650i), der zu jedem Steuersender auf der Studio-Sender-Verbindung (620i) gehört, unbekannt ist;

Berechnen einer ersten Checksumme über die mehreren Bytes, die Signalisierungs-Informationen enthalten;
Übertragen der mehreren Bytes und der ersten Checksumme in der vorbestimmten Anzahl von Transportstrompaketen über die Studio-Sender-Verbindung (620i),
hierbei Erzeugen einer Punkt-zu-Punkt-Kommunikationsverbindung,
Empfangen des Transportstroms von der Studio-Sender-Verbindung (620i);
Analysieren des Transportstroms, um den Paket-Identifizierer jedes Transportstrompakets zu erhalten;
Suchen nach einer vorbestimmten Anzahl von aufeinanderfolgenden Transportstrompaketen, die denselben Paket-Identifizierer haben;
Berechnen einer zweiten Checksumme eines Anteils der vorbestimmten Anzahl von Transportstrompaketen;
Vergleichen der ersten Checksumme mit der zweiten Checksumme;
Extrahieren der Signalisierungs-Information, falls die erste Checksumme und die zweite Checksumme gleich sind; und
Benutzen der Signalisierungs-Informationen, die aus dem Extrahieren gewonnen werden, um die Datenrahmensynchronisierung durchzuführen.

2. Verfahren nach Patentanspruch 1, das zusätzlich folgenden Verfahrensschritt enthält:

Rücksetzen der mehreren Bytes, die die Signalisierungs-Informationen enthalten, mit Dummy-Bytes im Post-Prozessor (650i).

3. Verfahren nach Patentanspruch 1,
wobei die Signalisierungs-Information eine Unterdatenrahmen-Nummer und eine Zeitschlitz-Nummer enthalten.

4. Verfahren nach Patentanspruch 1, das zusätzlich die folgenden Verfahrensschritte enthält:

Zuweisen eines Paket-Identifizierers, der in einem Speicher eines Post-Prozessors (650i) an der Studio-Sender-Verbindung (620i) vorabgespeichert ist;
Berechnen einer ersten Checksumme über die mehreren Dummy-Bytes, die Signalisierungs-Information enthalten; und
Übertragen der ersten Checksumme auf der Studio-Sender-Verbindung (620i) zum Post-Prozessor (650i).

5. Verfahren nach Patentanspruch 4, das zusätzlich die folgenden Verfahrensschritte enthält:

Empfangen des Transportstroms von der Studio-Sender-Verbindung (620i);
Analysieren des Transportstroms, um den Paket-Identifizierer von jedem Transportstrompaket zu erhalten;
Suchen nach der vorbestimmten Anzahl von aufeinanderfolgenden Transportstrompaketen, die im Speicher vorabgespeichert sind;
Berechnen einer zweiten Checksumme eines Anteils der vorbestimmten Anzahl von Transportstrompaketen;
Vergleichen der ersten Checksumme mit der zweiten Checksumme;
Extrahieren der Signalisierungs-Informationen, falls die erste Checksumme und die zweite Checksumme gleich sind; und
Benutzen der Signalisierungs-Informationen, die vom Extrahieren erhalten werden, um die Datenrahmensynchronisierung durchzuführen.

6. System zur Durchführung einer Datenrahmensynchronisierung von M/H-Datenrahmen, das aufweist:

einen Gruppen-Formatierer (606), der betreibbar ist, um eine vorbestimmte Anzahl von Dummy-Bytes, die von einer Kopfstation zu mehreren Steuersendern in einem Monofrequenznetz auf einer Studio-Sender-Verbindung (620i) übertragen werden, mit mehreren Bytes, die Signalisierungs-Informationen enthalten, zu ersetzen;
einen Multiplexer (614), der betreibbar ist, um einen Paket-Identifizierer einer vorbestimmten Anzahl von Transportstrompaketen zuzuweisen, wobei der Paket-Identifizierer einem Post-Prozessor (650i), der zu jedem Steuersender an der Studio-Sender-Verbindung (620i) gehört, unbekannt ist;
einen Checksummen-Berechner, der betreibbar ist, um eine erste Checksumme über die mehreren Bytes, die Signalisierungs-Informationen enthalten, zu berechnen;
einen Paket-Übertrager, der betreibbar ist, um die mehreren Bytes in der vorbestimmten Anzahl von Transportstrompaketen und die erste Checksumme über die Studio-Sender-Verbindung (620i) zum Post-Prozessor (650i) zu übertragen,
einen Paket-Empfänger, der betreibbar ist, um den Transportstrom von der Studio-Sender-Verbindung (620i) zu empfangen;
einen Analysator, der betreibbar ist, um:

den Transportstrom analysiert, um den Paket-Identifizierer jedes Transportstrompaketes zu erhalten,
eine vorbestimmte Anzahl von aufeinander folgenden Transportstrompaketen sucht, die den gleichen Paket-Identifizierer aufweisen,
eine zweite Checksumme eines Anteils der vorbestimmten Anzahl von Transportstrompaketen berechnet,
die erste Checksumme mit der zweiten Checksumme vergleicht,
die Signalisierungs-Informationen extrahiert, falls die erste Checksumme und die zweite Checksumme gleich sind, und
die Signalisierungs-Informationen benutzt, um die Datenrahmensynchronisierung durchzuführen.

7. System nach Patentanspruch 6,
wobei die mehreren Bytes, die Signalisierungs-Informationen enthalten, mit den Dummy-Bytes am Post-Prozessor zurückgesetzt werden.

8. System nach Patentanspruch 6,
wobei die Signalisierungs-Informationen eine Unterdatenrahmen-Nummer und eine Zeitschlitz-Nummer enthalten.

9. System nach Patentanspruch 6, das zusätzlich aufweist:

einen Multiplexer (614), der betreibbar ist, um einen Paket-Identifizierer einer vorbestimmten Anzahl von Transportstrompaketen zuzuweisen, wobei der Paket-Identifizierer in einem Speicher eines Post-Prozessors (650i) an einer Studio-Sender-Verbindung (620i) vorabgespeichert ist;
einen Checksummen-Berechner, der eine erste Checksumme über die mehreren Bytes, die Signalisierungs-Informationen enthalten, berechnet; und
wobei der Paket-Übertrager weiter betreibbar ist, um die erste Checksumme auf der Studio-Sender-Verbindung (620i) zum Post-Prozessor (650i) zu übertragen.

10. System nach Patentanspruch 9, das zusätzlich aufweist:

einen Paket-Empfänger, der betreibbar ist, um den Transportstrom von der Studio-Sender-Verbindung (620i) zu empfangen;
einen Prozessor, der betreibbar ist, um:

den Transportstrom zu analysieren, um die Paket-Identifizierer jedes Transportstrompaketes zu erhalten;
die vorbestimmte Anzahl von aufeinanderfolgenden Transportstrompaketen sucht, die denselben Paket-Identifizierer aufweisen;
eine zweite Checksumme eines Anteils der vorbestimmten Anzahl von Transportstrompaketen berechnet;
die erste Checksumme mit der zweiten Checksumme vergleicht;
die Signalisierungs-Informationen extrahiert, falls die erste Checksumme und die zweite Checksumme gleich sind; und
die Signalisierungs-Informationen, die vom Extrahieren gewonnen werden, benutzt, um die Datenrahmensynchronisierung durchzuführen.

11. Maschinenlesbarer Träger mit darauf gespeicherten Befehlssequenzen, wobei die Befehlssequenzen Befehle enthalten, die, wenn sie auf einem Computersystem ausgeführt werden, das Computersystem veranlassen, folgende Verfahrensschritte durchzuführen:

Ersetzen einer vorbestimmten Anzahl von Dummy-Bytes, die von einer Kopfstation zu mehreren Steuersendern in einem Monofrequenznetz auf einer Studio-Sender-Verbindung (620i) zu übertragen sind, mit mehreren Bytes, die Signalisierungs-Informationen enthalten;
Zuweisen eines Paket-Identifizierers einer vorbestimmten Anzahl von Transportstrompaketen, wobei der Paket-Identifizierer dem Post-Prozessor (650i), der zu jedem Steuersender auf der Studio-Sender-Verbindung (620i) gehört, unbekannt ist;
Berechnen einer ersten Checksumme anhand der mehreren Bytes, die Signalisierungs-Informationen enthalten;
Übertragen der mehreren Bytes und der ersten Checksumme in der vorbestimmten Anzahl von Transportstrompaketen über die Studio-Sender-Verbindung (620i),

Empfangen des Transportstroms von der Studio-Sender-Transportverbindung (620i);
Analysieren des Transportstroms, um den Paket-Identifizierer jedes Transportstrompakets zu erhalten;
Suchen nach einer vorbestimmten Anzahl von aufeinanderfolgenden Transportstrompaketen, die denselben Paket-Identifizierer haben;
Berechnen einer zweiten Checksumme eines Anteils der vorbestimmten Anzahl von Transportstrompaketen;
Vergleichen der ersten Checksumme mit der zweiten Checksumme;
Extrahieren der Signalisierungs-Information, falls erste Checksumme und zweite Checksumme gleich sind; und
Benutzen der Signalisierungs-Informationen, die aus dem Extrahieren gewonnen wird, um die Datenrahmensynchronisierung von M/H-Datenrahmen durchzuführen.

12. Maschinenlesbarer Träger nach Patentanspruch 11 mit zusätzlich darauf gespeicherten Sequenzen von Befehlen, die, wenn sie auf einem Computersystem ausgeführt werden, das Computersystem veranlassen, folgende Verfahrensschritte durchzuführen:

Rücksetzen der mehreren Bytes, die die Signalisierungs-Informationen enthalten, mit Dummy-Bytes im Post-Prozessor (650i).

13. Maschinenlesbarer Träger nach Patentanspruch 11, wobei die Signalisierungs-Information eine Unterdatenrahmen-Nummer und eine Zeitschlitz-Nummer enthält.

14. Maschinenlesbarer Träger nach Patentanspruch 11 mit zusätzlich darauf gespeicherten Sequenzen von Befehlen, die, wenn sie auf einem Computersystem ausgeführt werden, das Computersystem veranlassen, folgende Verfahrensschritte durchzuführen:

Zuweisen eines Paket-Identifizierers einer vorbestimmten Anzahl von Transportstrompaketen, wobei der Paket-Identifizierer der in einem Speicher eines Post-Prozessors (650i) an der Studio-Sender-Verbindung (620i) vorabgespeichert ist;
Berechnen einer ersten Checksumme über die mehreren Dummy-Bytes, die eine Signalisierungs-Information enthalten; und
Übertragen der ersten Checksumme auf der Studio-Sender-Verbindung (620i) zum Post-Prozessor (650i).

15. Maschinenlesbarer Träger nach Patentanspruch 11 mit zusätzlich darauf gespeicherten Sequenzen von Befehlen, die, wenn sie auf einem Computersystem ausgeführt werden, das Computersystem veranlassen, folgende Verfahrensschritte durchzuführen:

Empfangen des Transportstroms von der Studio-Sender-Verbindung (620i);
Analysieren des Transportstroms, um den Paket-Identifizierer von jedem Transportstrompaket zu erhalten;
Suchen nach der vorbestimmten Anzahl von aufeinanderfolgenden Transportstrompaketen, die im Speicher vorabgespeichert sind;
Berechnen einer zweiten Checksumme eines Anteils der vorbestimmten Anzahl von Transportstrompaketen;
Vergleichen der ersten Checksumme mit der zweiten Checksumme;
Extrahieren der Signalisierungs-Informationen, falls die erste Checksumme und die zweite Checksumme gleich sind; und
Benutzen der Signalisierungs-Informationen, die vom Extrahieren erhalten werden, um die Datenrahmensynchronisierung durchzuführen.

**Revendications**

1. Procédé pour effectuer une synchronisation de trames de données de trames de données M/H, comportant les étapes consistant à :

remplacer un nombre prédéterminé d'octets fictifs à transmettre depuis une tête de réseau à plusieurs excitateurs dans un réseau à réseau unique sur une liaison studio/transmetteur (620i) comportant une pluralité d'octets contenant une information de signalisation ;
assigner un identifiant de paquet à un nombre prédéterminé de paquets de flux de transport, l'identifiant de paquet étant inconnu à un post processeur (650i) appartenant à chaque excitateur sur la liaison studio/transmetteur (620i) ;

calculer une première somme de contrôle sur la pluralité d'octets contenant l'information de signalisation;

transmettre la pluralité d'octets et la première somme de contrôle dans le nombre prédéterminé de paquets de flux de transport par l'intermédiaire de la liaison studio/transmetteur (620i),

créer ainsi une liaison de communication point à point,

recevoir le flux de transport à partir de la liaison studio/transmetteur (620i) ;

analyser le transport pour obtenir l'identifiant de paquet de chaque paquet de flux de transport ;

rechercher un nombre prédéterminé de paquets de flux de transports consécutifs possédant le même identifiant de paquet ;

calculer une seconde somme de contrôle d'une partie du nombre prédéterminé de paquets de flux de transport ;

comparer la première somme de contrôle et la seconde somme de contrôle ;

extraire l'information de signalisation si la première somme de contrôle et la seconde somme de contrôle sont les mêmes ; et

utiliser l'information de signalisation obtenue à partir de ladite extraction pour effectuer une synchronisation de trames.

2. Procédé selon la revendication 1, comportant en outre :

la réinitialisation de la pluralité d'octets contenant l'information de signalisation avec les octets fictifs au post processeur (650i).

3. Procédé selon la revendication 1,

dans lequel l'information de signalisation comprend un nombre de sous-trame et un nombre d'intervalle.

4. Procédé selon la revendication 1, comportant en outre :

l'assignation d'un identifiant de paquet pré-mémorisé dans une mémoire d'un post processeur (650i) sur la liaison studio/transmetteur (620i) ;

le calcul d'une première somme de contrôle sur la pluralité de d'octets fictifs contenant l'information de signalisation ; et

la transmission de la première somme de contrôle sur la liaison studio/transmetteur (620i) au post processeur (650i).

5. Procédé selon la revendication 4, comportant en outre :

la réception du flux de transport à partir de la liaison studio/transmetteur (620i) ;

l'analyse du flux de transport pour obtenir l'identifiant de paquet de chaque paquet de flux de transport ;

la recherche du nombre prédéterminé de paquets de flux de transports consécutifs pré-mémorisés dans la mémoire;

le calcul d'une seconde somme de contrôle d'une partie du nombre prédéterminé de paquets de flux de transport ;

la comparaison de la première somme de contrôle de la seconde somme de contrôle ;

l'extraction de l'information de signalisation si la première somme de contrôle et la seconde somme de contrôle sont les mêmes ; et

l'utilisation de l'information de signalisation obtenue à partir de ladite extraction pour effectuer une synchronisation de trames.

6. Système pour effectuer une synchronisation de trames de données de trames de données M/H, comportant :

un dispositif de mise en forme de groupes (606) pouvant remplacer un nombre prédéterminé d'octets fictifs à transmettre depuis une tête de réseau à plusieurs excitateurs dans un réseau à fréquence unique sur une liaison studio/transmetteur (620i) comportant une pluralité d'octets contenant une information de signalisation ;

un multiplexeur (614) permettant d'assigner un identifiant de paquet à un nombre prédéterminé de paquets de flux de transport, l'identifiant de paquet étant inconnu à un post processeur (650i) appartenant à chaque excitateur sur la liaison studio/transmetteur (620i) ;

un calculateur de somme de contrôle permettant de calculer une première somme de contrôle sur la pluralité d'octets contenant l'information de signalisation ;

un transmetteur de paquets permettant de transmettre la pluralité d'octets dans le nombre prédéterminé de paquets de flux de transport et la première somme de contrôle par l'intermédiaire de la liaison studio/transmetteur (620i) au post processeur (650i),

un récepteur de paquets permettant de recevoir le flux de transport depuis la liaison studio/transmetteur (620i) ; un analyseur permettant de :

analyser le flux de transport pour obtenir l'identifiant de paquet de chaque paquet de flux de transport, rechercher un nombre prédéterminé de paquets de flux de transports consécutifs possédant le même identifiant de paquet, calculer une seconde somme de contrôle d'une partie du nombre prédéterminé de paquets de flux de transport, comparer la première somme de contrôle et la seconde somme de contrôle, extraire l'information de signalisation si la première somme de contrôle et la seconde somme de contrôle sont les mêmes, et utiliser l'information de signalisation pour effectuer une synchronisation de trames.

7. Système selon la revendication 6, dans lequel la pluralité d'octets contenant l'information de signalisation sont réinitialisés avec des octets fictifs au post processeur.

8. Système selon la revendication 6, dans lequel l'information de signalisation comprend un nombre de sous-trame et un nombre d'intervalle.

9. Système selon la revendication 6, comportant en outre :

un multiplexeur (614) permettant d'assigner un identifiant de paquet à un nombre prédéterminé de paquets de flux de transport, l'identifiant de paquet étant pré-mémorisé dans une mémoire d'un post processeur (650i) sur une liaison studio/transmetteur (620i) ; un calculateur de somme de contrôle permettant de calculer une première somme de contrôle sur la pluralité d'octets contenant l'information de signalisation ; et le transmetteur de paquets permettant en outre de transmettre la première somme de contrôle sur la liaison studio/transmetteur (620i) au post processeur (650i).

10. Système selon la revendication 9, comportant en outre :

un récepteur de paquets permettant de recevoir le flux de transport depuis la liaison studio/transmetteur (620i) ; un processeur permettant de :

analyser le flux de transport pour obtenir l'identifiant de paquet de chaque paquet de flux de transport ; rechercher le nombre prédéterminé de paquets de flux de transport consécutifs possédant le même identifiant de paquet ; calculer une seconde somme de contrôle d'une partie du nombre prédéterminé de paquets de flux de transport ; comparer la première somme de contrôle et la seconde somme de contrôle ; extraire l'information de signalisation si la première somme de contrôle et la seconde somme de contrôle sont les mêmes ; et utiliser l'information de signalisation obtenue à partir de ladite extraction pour effectuer une synchronisation de trames.

11. Support pouvant être lu par un ordinateur comportant des séquences d'instructions mémorisées, les séquences d'instructions comprenant des instructions qui, lorsqu'elle est exécutée par un système informatique, amène le système informatique à effectuer :

le remplacement d'un nombre prédéterminé d'octets fictifs à transmettre depuis une tête de réseau à plusieurs excitateurs dans un réseau à fréquence unique sur une liaison studio/transmetteur (620i) avec une pluralité d'octets contenant une information de signalisation ; l'assignation d'un identifiant de paquet à un nombre prédéterminé de paquets de flux de transport, l'identifiant de paquet étant inconnu à un post processeur (650i) appartenant à chaque excitateur sur la liaison studio/transmetteur (620i) ; le calcul d'une première somme de contrôle sur la pluralité d'octets contenant l'information de signalisation; la transmission de la pluralité d'octets de la première somme de contrôle dans le nombre prédéterminé de paquets de flux de transport par l'intermédiaire de la liaison studio/transmetteur (620i),

la réception du flux de transport à partir de la liaison studio/transmetteur (620i) ;

l'analyse du flux de transport pour obtenir l'identifiant de paquet de chaque paquet de flux de transport ;

la recherche d'un nombre prédéterminé de paquets de flux de transports consécutifs possédant le même identifiant de paquet ;

le calcul d'une seconde somme de contrôle d'une partie du nombre prédéterminé de paquets de flux de transport ;

la comparaison de la première somme de contrôle et de la seconde somme de contrôle ;

l'extraction de l'information de signalisation si la première somme de contrôle et la seconde somme de contrôle sont les mêmes ; et

l'utilisation de l'information de signalisation obtenue à partir de ladite extraction pour effectuer une synchronisation de trame des trames de données M/H.

12. Support pouvant être lu par un ordinateur selon le revendication 11, possédant en outre une séquence d'instructions mémorisées, qui, lorsqu'elle est exécutée par un système informatique, amène le système informatique à effectuer :

la réinitialisation de la pluralité d'octets contenant l'information de signalisation avec des octets fictifs au post processeur (650i).

13. Support pouvant être lu par un ordinateur selon la revendication 11, dans lequel l'information de signalisation comprend un nombre de sous-trame et un nombre d'intervalle.

14. Support pouvant être lu par un ordinateur selon la revendication 11, comportant en outre une séquence d'instructions mémorisées, qui, lorsqu'elle est exécutée par un système informatique, amène le système informatique à effectuer :

l'assignation d'un identifiant de paquet à un nombre prédéterminé de paquets de flux de transport, l'identifiant de paquet étant pré-mémorisé dans une mémoire d'un post processeur (650i) sur la liaison studio/transmetteur (620i) ;

le calcul d'une première somme de contrôle sur la pluralité d'octets fictifs contenant l'information de signalisation ; et

la transmission de la première somme de contrôle sur la liaison studio/transmetteur (620i) au post processeur (650i).

15. Support pouvant être lu par un ordinateur selon la revendication 11, comportant en outre une séquence d'instructions mémorisées, qui, lorsqu'elle est exécutée par un système informatique, amène le système informatique à effectuer :

la réception du flux de transport à partir de la liaison studio/transmetteur (620i) ;

l'analyse du flux de transport pour obtenir l'identifiant de paquet de chaque paquet de flux de transport ;

la recherche d'un nombre prédéterminé de paquets de flux de transports consécutifs possédant le même identifiant de paquet ;

le calcul d'une seconde somme de contrôle d'une partie du nombre prédéterminé de paquets de flux de transport ;

la comparaison de la première somme de contrôle et de la seconde somme de contrôle ;

l'extraction de l'information de signalisation si la première somme de contrôle et la seconde somme de contrôle sont les mêmes ; et

l'utilisation de l'information de signalisation obtenue à partir de ladite extraction pour effectuer une synchronisation de trames.

ATSC A/153 Mobile DTV

102

```
A/53
8-VSB
```

104                              106

| Deterministic Frame Offset | Trellis Init |    System Core
                                               Functions

108                              110

| Training Signals | SCCC |       ┌ ─ ─ ─ ─ ─ ┐
                                  |   No    |    Enhancement
                                  |   SFN   |      Tools
                                  └ ─ ─ ─ ─ ─ ┘

112

| M/H A/153 |                     Enhanced
                                     ATSC
                                  Mobile DTV

**FIG. 1**
(PRIOR ART)

21

**FIG. 2**
(PRIOR ART)

Main service data

M/H service data

Packet timing & PCR adjustment — 218

Pre-processor — 204, 220

202

206i

M/H frame encoder — 210

Block processor — 212

Group formatter — 214

Packet formatter — 216

Signaling encoder — 213

Packet mux

STL

Post-processor — 222i

Modified data randomizer — 226i

Systematic/ non-systematic RS encoder — 228i

Data interleaver — 230i

Parity replacer — 238i

Modified trellis encoder — 234i

Non-systematic RS encoder — 236i

Field sync, Segment sync

Sync mux — 240i

Pilot-inserter — 242i

Pre-equalizer filter (optional) — 244i

8-VSB modulator — 246i

RF up-converter — 248i

250i

224i

EP 2 291 937 B1

| M/H Group #0 118 Packets | Normal 38 Packets | Normal 156 Packets |
|---|---|---|

12.1 ms

| M/H Slot #0 | M/H Slot #1 | M/H Slot #2 | M/H Slot #3 | M/H Slot #4 | M/H Slot #5 | M/H Slot #6 | M/H Slot #7 | M/H Slot #8 | M/H Slot #9 | M/H Slot #10 | M/H Slot #11 | M/H Slot #12 | M/H Slot #13 | M/H Slot #14 | M/H Slot #15 |
|---|---|---|---|---|---|---|---|---|---|---|---|---|---|---|---|

1 M/H slot
= 156 TS packets

193.6 ms

| M/H Sub-Frame #0 | M/H Sub-Frame #1 | M/H Sub-Frame #2 | M/H Sub-Frame #3 | M/H Sub-Frame #4 |
|---|---|---|---|---|

1 M/H Sub-Frame
= 16 M/H Slots

968 ms

| M/H Frame |
|---|

1 M/H Frame
= 5 M/H Sub-Frames

## FIG. 3
(PRIOR ART)

A/153

Studio                                                                    Transmitter

———————— STL ————————→

Map TS packet #37
of M/H Slot #0 to
the first packet of          VSB Frame
odd VSB  data field

| M/H Slot #0 | TS packet #0 ~ #36 |
|  | TS packet #37 |
|  | TS packet #38 ~ #155 |

Map TS packet #37
of M/H Slot #1 to the
157th packet of odd
VSB data field

| M/H Slot #1 | TS packet #0 ~ #36 |
|  | TS packet #37 |
|  | TS packet #38 ~ #155 |

Odd VSB data field
of 312 TS packets

Map TS packet #37
of M/H Slot #2 to
the first packet of
even VSB  data field

| M/H Slot #2 | TS packet #0 ~ #36 |
|  | TS packet #37 |
|  | TS packet #38 ~ #155 |

Map TS packet #37
of M/H Slot #3 to the
157th packet of
even VSB data field

| M/H Slot #3 | TS packet #0 ~ #36 |
|  | TS packet #37 |
|  | TS packet #38 ~ #155 |

Even VSB data field
of 312 TS packets

## FIG. 4
### (PRIOR ART)

24

A/153 + SFN

FIG. 5

FIG. 6

EP 2 291 937 B1

EP 2 291 937 B1

Black Color
45 Dummy
Bytes

612

Main
service
data

Packet timing &
PCR adjustment

616

620i

600

Pre-processor

M/H service
data

M/H frame
encoder

Block
processor

Group
formatter

Packet
formatter

Packet
mux

602

604

Signaling
encoder

606

610

608

614

Each of the 45 Dummy Bytes in MH
Group has value 0xAF per A/153

**FIG. 7**

FIG. 8

Dummy Byte Signaling Syntax

| Packet # | Byte # | | | |
|----------|--------|--------------|-------------------------|-----------------------|
| 1 | 21 | Mode (1bit) | Subframe_num (3 bits) | Slot_num (4 bits) |
| 1 | 22 | Sync_time_stamp (24 bits) | | |
| 1 | 73 | | | |
| 1 | 74 | | | |
| 1 | 125 | Maximum_delay (24 bits) | | |
| 1 | 126 | | | |
| 1 | 177 | | | |
| 1 | 192 | System_time (2 bits) | MTxID (1 bit) | MTxID_align (2 bits) | Reserved (3 bits) |
| 2 | 22 | Adjusted_gps_seconds_count (32 bits) | | |
| 2 | 74 | | | |
| 2 | 126 | | | |
| 2 | 178 | | | |
| 2 | 192 | CRC-8 (8 bits) | | |

FIG. 9

EP 2 291 937 B1

**FIG. 10**
(PRIOR ART)

N/I

X2 ──N──►│Mux│──⊕──────────────────► Z2

1 of 12 Modified Trellis Encoder

1002

X1 ──N──►│Mux│───────────────────► Z1
N/I
Z0

1004

N : Normal mode

1006

I : Initialization mode

Truth Table
Exclusive OR Gate

| Input | Output |
|-------|--------|
| 00 | 0 |
| 01 | 1 |
| 10 | 1 |
| 11 | 0 |

1008

**FIG. 11**

1118

Packet#, Trellis Encoder#
[4,8] [3,9] [2,10] [1,11]

Packet#, Trellis Encoder#
[8,4] [7,5] [6,6] [5,7]

Packet#, Trellis Encoder#
[12,0] [11,1] [10,2] [9,3]

1116

Packet#,Byte#
[1,19] [2,19] [3,19] [4,19]

Packet#, Byte#
[5,23] [6,23] [7,23] [8,23]

Packet#, Byte#
[9,27] [10,27] [11,27] [12,27]

| Modified data randomizer | → | Systematic/ non-systematic RS encoder | → | Data interleaver | → | Parity replacer | → | Modified trellis encoder | → |

654i    656i    1114i    1108i    650i    660i

Non-systematic RS encoder

**Post-processor**

I : Initialization mode

1208                                                                                          1206

Trellis Encoder

FIG. 12

ATSC SFN Mode (No Mobile)

1302

Cadence every
12,480 Packets →
Inserted by Mux

VSB Sync Packet

Start Of VSB
Frame

1304

VSB Frame

Odd VSB data field
of 312 TS packets

Even VSB data
field
of 312 TS packets

FIG. 13

**188 Bytes**

## Fixed Locations of some Syntax

1410

| Header | Signaling | D T R | Reserved | D T R | Reserved | D T R | Reserved | C R C |
|---|---|---|---|---|---|---|---|---|

1 — 4

54 / 57

106 / 109

158 / 161

185 / 188

1402 1404 1408

1406

## VSB Sync Packet (VSP)

Advance on Byte

Advance every 207 Bytes

From → Reed-Solomon Encoder

1412

To → Pre-Coder and Trellis Encoder

VSP Byte **53-56** maps to (Trellis Coder **5,2,11,8**)

VSP Byte **105-108** maps to (Trellis Coder **9,6,3,12**)

VSP Byte **157-160** maps to (Trellis Coder **1,10,7,4**)

Frame (n)

Frame (n+1)

1414

**Memory map of ATSC 52 Segment Continuous Convolutional Byte Interleaver**

## FIG. 14

## VSB Sync Packet (VSP)

1502

| VSP Byte | Syntax | |
|---|---|---|
| 1<br>2<br>3<br>4 | Normal ATSC Header (32 bits)<br><br>PID can be a reserved value or<br>freely assigned by Mux and discovered by exciter | 1504 |
| 5 | Mode (1 bit), System Time (2 bits), Reserved (5 bits) | 1506 |
| 6<br>7<br>8 | Sync_time_stamp (24 bits) | 1508 |
| 9<br>10<br>11 | Max_Delay (24 bits) | 1510 |
| 12<br>13<br>14<br>15 | Adjusted_gps_seconds_count (24 bits) | 1512 |
| 54<br>55<br>56<br>57 | DTR (32 bits all set '1') | 1514 |
| 106<br>107<br>108<br>109 | DTR (32 bits all set '1') | 1516 |
| 158<br>159<br>160<br>161 | DTR (32 bits all set '1') | 1518 |
| 185<br>186<br>187<br>188 | CRC-32  (32 bits) | 1520 |
| xxx | All remaining unused Bytes/ bits are<br>Reserved and set to '1' | 1522 |

## FIG. 15

35

Current Mode
Normal ATSC
VSP — 1602

↓

Check Mode
Bit — 1604

↓

Mode == '1' ? — 1606 —Yes→

No

↓

When '0'
Signals a Mode
Change to M/H — 1608

↓

Transition to
M/H
Start using
Dummy Byte
Signaling — 1610

Current Mode
ATSC M/H
Dummy Bytes — 1612

↓

Check Mode
Bit — 1614

↓

Mode == '1' ? — 1616 —Yes→

No

↓

When '0'
Signals a
Mode Change
to Normal
ATSC — 1618

↓

Transition to
Normal ATSC
Start using
using VSP
Signaling — 1620

**FIG. 16**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7532677 B
- US 20060245516 A1
- US 7532857 B
- US 468938 A
- US 2010111109 A1
- US 2024238 A
- US 2008211969 A1
- DE 102008031796
- DE 102008056703 A1
- US 024238 A